# EUROPÄISCHE PATENTSCHRIFT

(11) **EP 4 391 737 B1**
(45) Veröffentlichungstag und Bekanntmachung des Hinweises auf die Patenterteilung: **28.01.2026**
(21) Anmeldenummer: 22216518.5
(22) Anmeldetag: 23.12.2022
(51) Int. Cl.: H05K 1/14, H05K 7/14, H05K 7/20, G01R 1/00

(54) **MODUL FÜR EIN SCHALTGERÄT**
MODULE FOR A SWITCHING DEVICE
MODULE POUR UN APPAREIL DE COMMUTATION

(43) Veröffentlichungstag der Anmeldung: 26.06.2024
(73) Patentinhaber: K & N Schalterentwicklungsgesellschaft m.b.H., 1180 Wien (AT)
(72) Erfinder: Konrad, Andreas, 1030 Wien (AT); Hofer, Andreas, 8241 Limbach (AT)
(74) Vertreter: KLIMENT & HENHAPEL

(56) Entgegenhaltungen:
- EP-B1- 2 100 351
- DE-A1- 102007 046 493
- DE-A1- 102013 216 493
- DE-A1- 102014 018 779
- US-A- 6 137 691
- US-A1- 2015 261 266

## Beschreibung

### GEBIET DER ERFINDUNG

Die Erfindung betrifft ein Modul, insbesondere zur Anordnung in einem Schaltschrank eines Niederspannungsverteilers oder zum Einsatz in Kombination mit einem solchen Niederspannungsverteiler oder einer Verteilerdose, wobei das Modul ein Modulgehäuse umfasst, wobei innerhalb des Modulgehäuses ein abschnittsweise flexibler Leiterplattenverbund mit zumindest drei starren Leiterplattenabschnitten sowie mit zumindest zwei flexiblen Leiterplattenabschnitten angeordnet ist, wobei jeweils zumindest ein flexibler Leiterplattenabschnitt zwischen zwei benachbarten starren Leiterplattenabschnitten angeordnet und mit diesen zwei benachbarten starren Leiterplattenabschnitten signalleitend elektrisch verbunden ist, wobei der abschnittsweise flexible Leiterplattenverbund in Einbaulage innerhalb des Modulgehäuses eine dreidimensionale Struktur bildet, bei der zumindest ein erstes Paar zweier benachbarter starrer Leiterplattenabschnitte zueinander einen ersten Winkel einschließt und zumindest ein zweites Paar zweier benachbarter starrer Leiterplattenabschnitte zueinander einen zweiten Winkel einschließt.

### STAND DER TECHNIK

Aus dem Stand der Technik sind bereits eine Vielzahl an Ausführungen von Modulen zur Anordnung in einem Schaltschrank oder zum Einsatz in Kombination mit einem Niederspannungsverteiler oder einer Verteilerdose bekannt geworden, wobei solche Module jeweils ein Modulgehäuse aufweisen und beispielsweise als Messmodule zum Erfassen einer oder mehrerer Messgrößen in einem Niederspannungsnetz ausgeführt sein können. Weiters können solche Module beispielsweise als Kommunikationsmodul ausgeführt sein, wobei ein Kommunikationsmodul üblicherweise signaltechnisch mit zumindest einem Messmodul gekoppelt ist, wobei das gekoppelte Messmodul eine Schnittstelle zur Übergabe von erfassten digitalen Messdaten an das Kommunikationsmodul aufweist, und wobei das Kommunikationsmodul einen Datenspeicher zum Speichern der digitalen Messdaten aufweisen und/oder beispielsweise auch ein Anzeigendisplay zur Visualisierung der Messdaten aufweisen kann.

Die zum Betrieb eines solchen Moduls erforderlichen elektronischen Bauteile sind dazu üblicherweise auf zwei oder mehreren bestückbaren, herkömmlichen starren Leiterplatten im Inneren des Moduls angeordnet, wobei die zwei oder mehreren Leiterplatten aus Platzgründen meist stockweise übereinander angeordnet sind. Dazu werden jeweils zwei konventionelle Leiterplatten unter Einsatz von darauf befestigten Steckerverbindungen, sogenannten Stiftleistenverbindungen, doppelstöckig zusammengesteckt. Nachteilig an dieser herkömmlichen Ausführung ist, dass die Steckerverbindungen bzw. Stiftleistenverbindungen zwischen zwei oder mehreren konventionellen, starren Leiterplatten aufwändig in der Fertigung und zudem fehleranfällig hinsichtlich der Signalübertragung sind. Infolge mechanischer und insbesondere thermischer Belastungen, die bei der Handhabung und im laufenden Betrieb eines solchen Moduls üblicherweise auftreten, können Lötstellen zur Kontaktierung der Stiftleistenverbindungen an den jeweiligen Leiterplatten beschädigt und so die Signalübertragung zwischen den zwei oder mehreren mit Steckerverbindungen verbundenen Leiterplatten gestört werden.

Als weitere Nachteile einer solchen herkömmlichen Doppelstockanordnung von zwei oder mehreren im Wesentlichen parallel übereinander gestapelten Leiterplatten, die jeweils mit Steckerverbindungen signalleitend miteinander verbunden sind, sind der vergleichsweise große Platzbedarf sowie die fehlende Flexibilität bei der geeigneten Anordnung eines solchen voluminösen Pakets von zwei oder mehreren zusammengesteckten Leiterplatten im Inneren eines Moduls zu nennen. Nachteiliger Weise befinden sich beispielsweise elektronische Bauteile, die besonders temperaturempfindlich sind, auf derselben Leiterplatte oder zumindest in räumlicher Nähe mit anderen elektronischen Bauteilen bzw. elektronischen Komponenten, die im laufenden Betrieb Abwärme produzieren. Beispielsweise können Bauteile des Netzteiles eines solchen Moduls, die sich im Betrieb stark erwärmen und Abwärme abgeben, sich dabei negativ auf die für eine exakte Temperaturmessung erforderlichen, temperaturempfindlichen elektronischen Bauteile, Leiterbahnen und/oder Einzellagen (englisch: Layer) auswirken.

Unter dem Begriff "Leiterplatte" (Leiterkarte, Platine oder gedruckte Schaltung; englisch: printed circuit board, kurz: PCB) versteht der Fachmann allgemein einen Träger für elektronische Bauteile, wobei herkömmliche, starre Leiterplatten meist aus einem sogenannten FR4-Material aufgebaut sind. Der Begriff "FR-4" oder auch "FR4" bezeichnet eine Klasse von Leiterplattenbasismaterial aus schwer entflammbaren und flammenhemmenden Verbundwerkstoffen, bestehend aus Epoxidharz und Glasfasergewebe. Die Abkürzung FR steht für englisch "flame retardant", also für flammenhemmend. FR4-Standardmaterialien für die Leiterplattenfertigung weisen üblicherweise eine Glasübergangstemperatur TG von zumindest 135°C auf und sind nach dem Laminieren, also nach dem Aushärtevorgang bei erhöhter Temperatur und/oder bei erhöhtem Druck, im Wesentlichen starr. Generell dienen solche starren, konventionellen Leiterplatten, die üblicherweise mehrlagig aufgebaut sind, zur mechanischen Befestigung und elektrischen Verbindung der darauf befestigten und/oder darin eingebetteten elektronischen Bauteile.

Unter dem Begriff "elektronisches Bauteil" kann in diesem Zusammenhang beispielsweise jedes aktive elektronische Bauelement wie ein Chip, insbesondere ein Halbleiterchip, und/oder jedes passive elektronische Bauelement wie ein Kondensator, ein Widerstand, eine Induktivität oder ein magnetisches Element, beispielsweise ein Ferritkernelement, verstanden werden. Weitere Beispiele für elektronische Bauteile, die in eine Leiterplatte eingebettet oder darauf positioniert werden können, sind Datenspeicher wie ein dynamischer Direktzugriffsspeicher (DRAM), Filter, die beispielsweise als Hochpassfilter, Tiefpassfilter oder Bandfilter konfiguriert oder die als Frequenzfilter verwendet werden können. Auch eine integrierte Schaltung (IC) wie ein sogenannter Logik-IC, jede Signalverarbeitungskomponente wie ein Mikroprozessor, jede Leistungsmanagementkomponente, jedes optoelektronische Gerät, jeder Spannungswandler wie DC/DC-Wandler oder AC/DC-Wandler, jeder elektromechanische Wandler wie ein Blei-Zirkonium-Titanat (PZT)-Sensor und/oder -Aktor, sowie jede Sendeeinheit oder Empfangseinheit für elektromagnetische Wellen wie ein RFID-Chip oder -Transponder, jede kryptografische Komponente, Kapazität, Induktivität oder Schalter wie ein transistorbasierter Schalter allein oder in Kombination mit den vorgenannten oder zusammen mit anderen funktionalen elektronischen Komponenten ist von dem vorgenannten Begriff eines elektronischen Bauteils umfasst. Weiterhin kann ein elektronisches Bauteil auch ein mikroelektromechanisches System (kurz MEMS), eine Batterie, einen Akkumulator, ein Netzteil, eine Kamera oder eine Antenne umfassen. Es können jedoch auch andere elektronische Bauteile bzw. Komponenten in eine Leiterplatte eingebettet sein. Als elektronisches Bauteil kann beispielsweise ein magnetisches Element verwendet werden. Ein solches magnetisches

Element kann ein permanentmagnetisches Element sein, wie beispielsweise ein ferromagnetisches Element, ein antiferromagnetisches Element oder ein ferrimagnetisches Element, beispielsweise ein Ferritkern, oder kann ein paramagnetisches Element sein. Ein solches elektronisches Bauteil kann auf einer Leiterplatte oberflächenmontiert und/oder in deren Innerem eingebettet sein.

Die DE 10 2014 018779 A1 offenbart eine Messeinrichtung zur Erfassung von Energiedaten umfassend eine Datenverarbeitungseinheit und ein mit dieser verbundenes Sensormodul, sowie ein Verfahren zum Betrieb einer solchen Messeinrichtung und ein System umfassend die Messeinrichtung und einen Schaltschrank.

Die DE 10 2013 216493 A1 offenbart eine Leiterplatte, welche in mehrere starre Abschnitte unterteilt ist, wobei die einzelnen starren Abschnitte der Leiterplatte mit flexiblen Leiterplattenabschnitten verbunden sind. Die DE102007046493A1 offenbart einen dreidimensionalen Formkörper, welcher entweder aus zusammengefügten Platinen hergestellt wird oder durch Biegen einer Substratgrundplatte. Befestigungstechniken zum Verbinden der einzelnen Platinen umfassen eine fixierende mechanische so genannte gezinkte Eckverbindung zwischen einer ersten Substratplatten-Wandung und einer zweiten Substratplatten-Wandung, bei der an den beiden benachbarten zu verbindenden Kanten der Substratplatten-Wandungen raumformmäßig aufeinander abgestimmte, z. B. quaderförmige Zinken bzw. Zähne und Zahnlücken zwischen den Zähnen angeordnet sind, wobei Metallschichten zwischen benachbarten Zähnen miteinander z.B. verlötet sein können.

### AUFGABE DER ERFINDUNG

Es ist daher eine Aufgabe der Erfindung, die Nachteile des Stands der Technik zu überwinden und ein Modul vorzuschlagen, bei dem die elektronischen Bauteile im Inneren eines Modulgehäuses des Moduls möglichst robust und ausfallsicher angeordnet sind, wobei die Signalübertragung zwischen den einzelnen elektronischen Bauteilen verbessert wird, und wobei insbesondere jene elektronischen Bauteile, die temperaturempfindlich sind **bzw.** die für eine exakte Temperaturmessung erforderlich sind, innerhalb des Innenraums des Modulgehäuses möglichst räumlich getrennt von anderen wärmeproduzierenden elektronischen Bauteilen angeordnet sind, so dass unerwünschte Einflüsse aufgrund von Wärmeentwicklung im laufenden Betrieb des Moduls die Funktionalität der temperaturempfindlichen elektronischen Bauteile nicht beeinträchtigen.

### DARSTELLUNG DER ERFINDUNG

Diese Aufgabe wird bei einem Modul der eingangs genannten Art, in welchem innerhalb des Modulgehäuses ein abschnittsweise flexibler Leiterplattenverbund mit zumindest drei starren Leiterplattenabschnitten sowie mit zumindest zwei flexiblen Leiterplattenabschnitten angeordnet ist, wobei jeweils zumindest ein flexibler Leiterplattenabschnitt zwischen zwei benachbarten starren Leiterplattenabschnitten angeordnet und mit diesen zwei benachbarten starren Leiterplattenabschnitten signalleitend elektrisch verbunden ist, wobei der abschnittsweise flexible Leiterplattenverbund in Einbaulage innerhalb des Modulgehäuses eine dreidimensionale Struktur bildet, bei der zumindest ein erstes Paar zweier benachbarter starrer Leiterplattenabschnitte zueinander einen ersten Winkel einschließt und zumindest ein zweites Paar zweier benachbarter starrer Leiterplattenabschnitte zueinander einen zweiten Winkel einschließt, erfindungsgemäß dadurch gelöst, dass zwei starre Leiterplattenabschnitte in Einbaulage innerhalb des Modulgehäuses mit einer formschlüssigen Steck- oder Rastverbindung zusammengefügt sind, wobei die formschlüssige Steck- oder Rastverbindung zusätzlich verlötet ist, wobei temperaturempfindliche elektronische Bauteile auf dem abschnittsweise flexiblen Leiterplattenverbund in Einbaulage der dreidimensionalen Struktur räumlich beabstandet von wärmeerzeugenden elektronischen Bauteilen angeordnet sind.

Vorteilhaft kann durch den Einsatz eines abschnittsweise flexiblen Leiterplattenverbunds mit zumindest drei starren Leiterplattenabschnitten sowie mit zumindest zwei flexiblen Leiterplattenabschnitten, die jeweils zwischen zwei benachbarten starren Leiterplattenabschnitten angeordnet sind, die insgesamt für das Bestücken mit elektronischen Bauteilen verfügbare starre Leiterplattenfläche vergrößert werden. Die Bestückungsdichte, also die Anzahl von elektronischen Bauteilen pro Leiterplattenfläche, kann somit vorteilhaft reduziert werden. Außerdem können temperaturempfindliche elektronische Bauteile bzw. jene elektronischen Bauteile, die für besonders temperaturempfindliche Messungen erforderlich sind, auf einem ersten starren Leiterplattenabschnitt angeordnet werden, während andere elektronische Bauteile, die im laufenden Betrieb des Moduls erhitzen und somit Abwärme produzieren, wie dies beispielsweise bei einem Netzteil der Fall ist, auf einem vom ersten starren Leiterplattenabschnitt weiter entfernten, zweiten bzw. weiteren starren Leiterplattenabschnitt angeordnet werden.

Um das vorhandene Innenraumvolumen des jeweiligen Modulgehäuses eines solchen Moduls bestmöglich ausnützen zu können, wird der abschnittsweise flexible Leiterplattenverbund in Einbaulage innerhalb des Modulgehäuses so angeordnet, dass der Leiterplattenverbund eine dreidimensionale Struktur bildet, bei der zumindest zwei Paare von jeweils zwei benachbarten starren Leiterplattenabschnitten zueinander jeweils einen Winkel einschließen. In Einbaulage innerhalb des Modulgehäuses bildet der erfindungsgemäße Leiterplattenverbund daher eine dreidimensionale Struktur, bei der ein erstes Paar zweier benachbarter starrer Leiterplattenabschnitte zueinander einen ersten Winkel einschließt und ein zweites Paar zweier benachbarter Leiterplattenabschnitte zueinander einen zweiten Winkel einschließt. Der erste Winkel und der zweite Winkel können gleich groß oder unterschiedlich groß sein. Gegebenenfalls vorhandene weitere starre Leiterplattenabschnitte können wiederum paarweise zueinander benachbart miteinander einen dritten bzw. weiteren Winkel einschließen. Ein solcher dritter bzw. weiterer Winkel zwischen einem dritten bzw. weiteren Paar zweier benachbarter starrer Leiterplattenabschnitte kann wiederum gleich groß oder unterschiedlich groß in Bezug zum ersten und/oder zum zweiten Winkel sein.

Die jeweils paarweise benachbarten starren Leiterplattenabschnitte sind jeweils durch zumindest einen dazwischenliegend angeordneten, flexiblen Leiterplattenabschnitt beweglich bzw. gelenkig miteinander verbunden.

Abweichend von der eingangs beschriebenen, herkömmlichen Doppelstock-Anordnung von zwei herkömmlichen starren Leiterplatten, die parallel übereinander mittels einer konventionellen Stiftleistenverbindung signalleitend zusammengesteckt sind, bietet die erfindungsgemäße, räumliche bzw. dreidimensionale Struktur des Leiterplattenverbunds in Einbaulage innerhalb des Modulgehäuses den Vorteil, dass zumindest zwei Paare jeweils zweier benachbarter starrer Leiterplattenabschnitte nicht parallel, sondern jeweils unter einem Winkel zueinander angeordnet sind. Dadurch kann der räumliche Abstand zwischen elektronischen Bauteilen, die auf dem Leiterplattenverbund positioniert sind, vorteilhaft vergrößert werden. Negative Einflüsse infolge von unerwünschter Wärmeleitung und/oder Wärmestrahlung zwischen einzelnen elektronischen Bauteilen lassen sich durch geeignete Positionierung auf dem Leiterplattenverbund in räumlichem Abstand zwischen den betreffenden elektronischen Bauteilen weitestgehend reduzieren. Insbesondere können negative Beeinflussungen einer Temperaturmessung infolge von unerwünschter Abwärmeentwicklung im laufenden Betrieb eines Moduls durch die erfindungsgemäße räumliche Struktur in Einbaulage des Leiterplattenverbunds innerhalb des Moduls vermieden werden.

Ein solches erfindungsgemäßes Modul ist zwar zur Anordnung in einem Schaltschrank eines Niederspannungsverteilers oder zum Einsatz in Kombination mit einem solchen Niederspannungsverteiler oder einer Verteilerdose geeignet, sein Einsatz ist jedoch nicht auf die vorgenannten Anordnungen beschränkt.

Besonders flexibel und effizient lässt sich ein solcher Leiterplattenverbund an ein individuelles Modulgehäuse eines Moduls anpassen, wenn bei einem Modul gemäß der Erfindung jeweils zwei benachbarte starre Leiterplattenabschnitte zueinander einen Winkel in einem Bereich von 10° bis 170°, vorzugsweise in einem Bereich von 30° bis 150°, besonders bevorzugt in einem Bereich von 60° bis 120°, einschließen.

In dieser Ausführung der Erfindung kann ein Leiterplattenverbund flexibel innerhalb eines Modulgehäuses an die jeweilige Gehäusegeometrie angepasst werden, sodass einerseits der zur Verfügung stehende Innenraum des Modulgehäuses bestmöglich von der räumlichen, dreidimensionalen Struktur des Leiterplattenverbunds ausgenützt wird, und andererseits elektronische Bauteile, die im laufenden Betrieb des Moduls erhitzen und somit Abwärme produzieren, wie dies beispielsweise bei einem Netzteil der Fall ist, auf einem starren Leiterplattenabschnitt räumlich getrennt bzw. weiter entfernt von hitzeempfindlichen elektronischen Bauteilen, die auf weiteren starren Leiterplattenabschnitten positioniert sind, angeordnet werden können.

Gemäß einer ersten Variante der Erfindung kann es vorteilhaft sein, wenn bei einem Modul die Winkel zwischen jeweils zwei benachbarten starren Leiterplattenabschnitten des Leiterplattenverbunds jeweils gleich groß sind.

Beispielsweise können bei einem symmetrisch geformten Modulgehäuse, insbesondere bei einem im Wesentlichen quaderförmigen oder würfelförmigen Modulgehäuse, die starren Leiterplattenabschnitte, welche vom abschnittsweise flexiblen Leiterplattenverbund umfasst sind, jeweils im Wesentlichen rechtwinkelig, also jeweils in einem Winkel von im Wesentlichen 90°, in Bezug zu einem jeweils dazu benachbarten starren Leiterplattenabschnitt angeordnet sein. Die jeweils zwischen zwei benachbarten starren Leiterplattenabschnitten angeordneten, flexiblen Leiterplattenabschnitte, die zur signalleitenden, elektrischen Verbindung der jeweils angrenzenden starren Leiterplattenabschnitte dienen, sind in einem solchen Fall beispielsweise jeweils in einem Biegeradius mit einem Biegewinkel von etwa 90° gebogen und somit jeweils gleich groß.

Gemäß einer alternativen, zweiten Variante der Erfindung kann es vorteilhaft sein, wenn bei einem Modul die Winkel zwischen jeweils zwei benachbarten starren Leiterplattenabschnitten jeweils unterschiedlich groß und/oder in Gruppen unterschiedlich groß sind.

Diese erfindungsgemäße räumliche Anordnung eines abschnittsweise flexiblen Leiterplattenverbunds in Einbaulage im Innenraum des Modulgehäuses bietet den Vorteil, besonders flexibel an individuelle Geometrien unterschiedlicher Modulgehäuse angepasst werden zu können. So können beispielsweise Nischen oder Vorsprünge in einem Modulgehäuse ausgenützt werden, um darin entsprechende Leiterplattenabschnitte des Leiterplattenverbunds unterzubringen.

Auch die Auswahl des bzw. der Winkel jeweils zwischen zwei benachbarten starren Leiterplattenabschnitten in Einbaulage kann an die jeweiligen geometrischen Rahmenbedingungen unterschiedlicher Modulgehäuse angepasst werden. Im Falle eines Modulgehäuses, das von einer symmetrischen Quader- oder Würfelform abweicht, und das beispielsweise Einkerbungen, Nischen, Vorsprünge, und/oder Konturabschnitte in Form eines Polyeders oder eines Rotationskörpers aufweist, kann es zweckmäßig sein, wenn die Winkel zwischen paarweise benachbarten starren Leiterplattenabschnitten in Einbaulage der dreidimensionalen Struktur des Leiterplattenverbunds im Innenraum des Modulgehäuses jeweils unterschiedlich groß oder gruppenweise unterschiedlich groß sind.

Besonders vorteilhaft kann es sein, wenn bei einem erfindungsgemäßen Modul jeder starre Leiterplattenabschnitt in Einbaulage innerhalb des Modulgehäuses jeweils eine, vorzugsweise jeweils eine eigene, Ebene der dreidimensionalen Struktur bildet. Gemäß dieser Ausführungsvariante der Erfindung kann der zur Verfügung stehende Innenraum des Modulgehäuses möglichst gut ausgenützt werden, um darin den abschnittsweise flexiblen Leiterplattenverbund in Einbaulage innerhalb des Modulgehäuses als eine dreidimensionale Struktur mit möglichst großen Raumabständen zwischen den einzelnen starren Leiterplattenabschnitten anzuordnen. Auch werden in dieser Ausführungsvariante die mit elektronischen Bauteilen bestückbaren Flächen des Leiterplattenverbunds vorteilhaft vergrößert.

Die einzelnen starren Leiterplattenabschnitte können beispielsweise zumindest teilweise oder abschnittsweise entlang der Innenwandungen des Modulgehäuses angeordnet sein. Besonders zweckmäßig kann es sein, wenn die einzelnen starren Leiterplattenabschnitte an den Innenwandungen des Modulgehäuses zumindest abschnittsweise befestigt sind. In dieser Ausführung schließen alle Paare zweier jeweils benachbarter starrer Leiterplattenabschnitte jeweils zueinander einen Winkel miteinander ein.

In einem erfindungsgemäßen Modul kann eine besonders robuste dreidimensionale Struktur eines Leiterplattenverbundes angeordnet werden, wenn zumindest zwei starre Leiterplattenabschnitte in Einbaulage innerhalb des Modulgehäuses mit einer lösbaren formschlüssigen Verbindung miteinander verbindbar sind.

Beispielsweise können zwei oder mehrere starre Leiterplattenabschnitte in Einbaulage entweder direkt miteinander verbunden werden, um den jeweiligen Leiterplattenverbund in einer möglichst robusten dreidimensionalen Struktur zu fixieren. Alternativ dazu oder in Ergänzung dazu können beispielsweise mechanische Abstandhalter zwischen zwei starren Leiterplattenabschnitten angeordnet sein bzw. mit diesen formschlüssig und/oder stoffschlüssig verbunden sein, um einzelne starre Leiterplattenabschnitte miteinander zu verbinden. Zur Positionierung und Stabilisierung der betreffenden Leiterplattenabschnitte können beispielsweise sogenannte SMD-Abstandhalter (SMD, englisch; kurz für "Surface Mount Device") verwendet werden, die an Oberflächen einer starren Leiterplatte beispielsweise mittels Verschraubung oder Lötung befestigt werden.

In einer Weiterbildung des erfindungsgemäßen Moduls kann es zweckmäßig sein, wenn die lösbare formschlüssige Verbindung ausgewählt ist aus der Gruppe umfassend, vorzugsweise bestehend aus: Rastverbindung, Steckverbindung, Nut-Feder-Verbindung, Spundung, Passfeder-Verbindung, Reißverschluss-Verbindung, Klettverschluss-Verbindung.

Beispielsweise können die Ränder zweier starrer Leiterplattenabschnitte, die zueinander einen Winkel einschließen sowie einander berühren, komplementäre Vorsprünge bzw. Ausnehmungen nach Art einer Spundung aufweisen, wobei abstehende Federn oder zinkenförmige Elemente, die an den Rand eines der beiden zu verbindenden starren Leiterplattenabschnitte angearbeitet sind, in entsprechende Nuten des anderen starren Leiterplattenabschnitts eingefügt werden können. Eine solche Spundung kann beispielsweise in Form einer oder mehrerer Schwalbenschanzverbindungen bzw. Verzinkungen ausgeführt sein.

Um die dreidimensionale Struktur des Leiterplattenverbunds in seiner Einbaulage weiter zu stabilisieren, ist erfindungsgemäß vorgesehen, dass die formschlüssigen Steck- oder Rastverbindungen zweier starrer Leiterplattenabschnitte nach dem mechanischen bzw. formschlüssigen Zusammenfügen zusätzlich verlötet werden. Damit wird erreicht, dass der zusammengesteckte Leiterplattenverbund in Einbaulage auch bei mechanischen Belastungen, beispielsweise bei Erschütterungen, in Form bleibt und die zusammengesteckten starren Leiterplattenabschnitte mittels der Lötstellen zusätzlich auch stoffschlüssig miteinander verbunden sind.

Für den Fall, dass im Bereich der formschlüssigen Steck- oder Rastverbindung zweier starrer Leiterplattenabschnitte zusätzlich auch noch elektrische Kontaktleitungen hergestellt werden sollen, können beispielsweise an den zu verbindenden Rändern zweier starrer Leiterplattenabschnitte entsprechende Lötflächen sowie entsprechende elektrische Durchkontaktierungen (englisch: Vias) vorgesehen sein. Nach dem mechanischen bzw. formschlüssigen Zusammenfügen der einander berührenden starren Leiterplattenabschnitte können anschließend die zusammengehörigen Lötflächen und/oder Durchkontaktierungen verlötet werden, um entsprechende elektrische Kontaktleitungen zwischen den beiden miteinander verbundenen starren Leiterplattenabschnitten zu realisieren.

Alternativ oder in Ergänzung zu Nut-Feder-Verbindungen oder Spundungen können zwei benachbarte starre Leiterplattenabschnitte, die zueinander einen Winkel einschließen sowie einander berühren, auch als Rastverbindung, Steckverbindung, Passfeder-Verbindung, Reißverschluss-Verbindung und/oder Klettverschluss-Verbindung ausgeführt sein.

Um einen abschnittsweise flexiblen Leiterplattenverbund für ein erfindungsgemäßes Modul möglichst kostengünstig unter Einsatz von an sich bekannten Materialien bereitstellen zu können, kann es zweckmäßig sein, wenn der Leiterplattenverbund ausgewählt ist aus der Gruppe umfassend, vorzugsweise bestehend aus: starrflexibler Leiterplattenverbund, semiflexibler Leiterplattenverbund, flexibler Leiterplattenverbund verklebt auf Aluminiumplatten.

Alternativ zu herkömmlichen, starren Leiterplatten sind bereits sogenannte starrflexible Leiterplatten bekannt, die durch Verpressen einer Kombination von flexiblen und starren Schichten erhalten werden. Hier befinden sich beispielsweise flexible Polyimid-Folien auf oder zwischen gewöhnlichen FR4-Schichten, wobei nach einer entsprechenden Tiefenfräsung Bereiche mit unterschiedlicher Dicke und unterschiedlicher Flexibilität einer solchen starrflexiblen Leiterplatte erhalten werden. Aufgrund der flexiblen Leiterplattenabschnitte aus flexiblen Polyimid-Folien, die die jeweils angrenzenden starren Leiterplattenabschnitte aus herkömmlichen FR4-Schichten signalleitend elektrisch verbinden, wird eine verbesserte Signalübertragung zwischen den einzelnen elektronischen Bauteilen bzw. zwischen den einzelnen starren Leiterplattenabschnitten erzielt. Starrflexible Leiterplatten werden auch als "Rigid-Flex Leiterplatten" bezeichnet. Ein solcher starrflexibler Leiterplattenverbund ist besonders flexibel in seiner Handhabung, da die flexiblen Leiterplattenabschnitte aus flexiblen Polyimid-Folien erforderlichenfalls auch dynamisch verformt, beispielsweise gebogen, verdreht oder gefaltet, werden können.

Durch Einsatz eines starrflexiblen Leiterplattenverbunds lassen sich Stecker, Kabel und andere Verbindungselemente einsparen. Allerdings entsteht damit auch die Notwendigkeit, bei Defekten den gesamten starrflexiblen Leiterplattenverbund auswechseln zu müssen.

Eine weitere Alternative zu herkömmlichen, starren Leiterplatten bieten sogenannte semiflexible Leiterplatten. Für den Anwendungsfall, dass kein dauerhaft flexibler Bereich im Leiterplattenverbund benötigt wird, sondern um beispielsweise die einmalige Montage eines Leiterplattenverbunds bei begrenztem Platz in einem Modulgehäuse zu ermöglichen, kann ein aus mehreren Faserlagen aufgebauter Schichtstapel einer Leiterplatte bis auf wenige Lagen durch Fräsen oder durch Stanzen von ausgesparten Bereichen verjüngt werden. Die einzelnen mit Reaktionsharzen vorimprägnierten Faserlagen werden auch als prepregs bezeichnet.

Anstelle einer Polyimid-Folie wird hierzu ein Standard-Dünnlaminat FR4-Material verwendet, um eine kostengünstige Alternative zu starrflexiblen Leiterplatten zu haben. Der verjüngte Leiterplattenbereich wird typischerweise mit einer dauerflexiblen Lackschicht versehen und lässt sich dann einige wenige Male biegen. Ein solcher semiflexibler Leiterplattenverbund kann als kosteneffektive "Flex-to-Install"-Lösung eingesetzt werden, bei der also die gewünschte entsprechende räumliche Struktur des Leiterplattenverbunds einmal durch entsprechendes Biegen und/oder Falten der starren Leiterplattenabschnitte geformt und diese dann in das Modulgehäuse des entsprechenden Moduls eingesetzt wird. Auch solche semiflexiblen Leiterplattenverbunde, die aus starren Leiterplatten aus FR4-Material und dazwischenliegenden, eingeschränkt biegbaren Dünnlaminat-Abschnitten hergestellt sind, können im Rahmen der Erfindung als abschnittsweise flexibler Leiterplattenverbund eingesetzt werden.

Alternativ zu herkömmlichen, starren Leiterplatten finden auch flexible Leiterplatten in Form beispielsweise von dünnen Flexleiterplatten oder von Leiterfolien auf Basis von Polyimid-Folien Verwendung, die mit einem oder mit mehreren Aluminiumkühlkörper verklebt sind. Damit aufgebaute Baugruppen sind zwar teurer, können jedoch platzsparend durch Falten in engen Räumen eingesetzt werden. Durch die Verklebung der Polyimid-Flexleiterplatten mit Aluminiumkörpern, die beispielsweise Kühlrippen aufweisen können und als Kühlkörper zur Wärmeabfuhr der darauf bestückten elektronischen Bauteile dienen, können Leiterplattenverbünde bereitgestellt werden, die besonders gute Wärmeableitende Eigenschaften aufweisen und für die Bestückung mit temperaturempfindlichen elektronischen Bauteilen besonders geeignet sind.

Ein besonders langlebiges und exakt arbeitendes Modul wird gemäß der Erfindung bereitgestellt, wenn temperaturempfindliche elektronische Bauteile auf dem abschnittsweise flexiblen Leiterplattenverbund in Einbaulage der dreidimensionalen Struktur räumlich beabstandet von wärmeerzeugenden elektronischen Bauteilen angeordnet sind.

Auf diese Weise können die temperaturempfindlichen elektronischen Bauteile in Einbaulage der dreidimensionalen Struktur des abschnittsweise flexiblen Leiterplattenverbunds innerhalb des Modulgehäuses möglichst weit beabstandet von wärmeerzeugenden elektronischen Bauteilen im Innenraum des Modulgehäuses angeordnet werden, um unerwünschte Beeinflussungen aufgrund von Wärmestrahlung oder Wärmeleitung zwischen den elektronischen Bauteilen im Inneren des Modulgehäuses oder des Leiterplattenverbundes möglichst zu vermeiden.

Zweckmäßig kann es sein, ein platzsparendes Modul gemäß der Erfindung bereitzustellen, bei dem zumindest zwei gleich große starre Leiterplattenabschnitte ausgebildet sind, welche in Einbaulage des abschnittsweise flexiblen Leiterplattenverbunds innerhalb des Modulgehäuses einander gegenüberliegend angeordnet sind.

Diese Ausführung kann beispielsweise besonders platzsparend in Quader- oder Würfel-förmigen, somit in zumindest abschnittsweise symmetrisch geformten Modulgehäusen eingesetzt werden.

Um die verfügbare Bestückungsfläche bei einem Leiterplattenverbund weiter zu erhöhen bzw. umgekehrt die Bestückungsdichte des Leiterplattenverbunds weiter zu reduzieren, kann es vorteilhaft sein, wenn bei einem Modul gemäß der Erfindung zumindest ein starrer Leiterplattenabschnitt des Leiterplattenverbundes beidseitig auf zwei voneinander weg weisenden Außenseiten mit elektronischen Bauteilen bestückt ist. Gemäß dieser Ausführungsform können auch zwei oder mehrere oder aber sämtliche starren Leiterplattenabschnitte des innerhalb des Modulgehäuses angeordneten Leiterplattenverbunds jeweils beidseitig bestückt sein. Weiters können - wie vorhin bereits erwähnt - im Falle eines mehrlagigen Aufbaus der starren Leiterplattenabschnitte elektronische Bauteile auch innerhalb eines oder mehrerer starrer Leiterplattenabschnitte eingebettet, also mittels eines Laminierverfahrens unter Druck- und Temperaturbeaufschlagung innerhalb der FR4-Lagenstruktur des jeweiligen Leiterplattenabschnitts eingegossen sein.

Besonders vielfältig kann ein Modul gemäß der Erfindung eingesetzt werden, wenn das Modul ein Messmodul für ein Schaltgerät, insbesondere für einen Lasttrennschalter, zum Messen zumindest einer Messgröße in einem Niederspannungsnetz, und/oder ein Kommunikationsmodul ist.

Mit dem Begriff "Messmodul" wird hier ein Modul zum Messen zumindest einer Messgröße in einem Niederspannungsnetz bezeichnet, wobei das Messmodul ein Modulgehäuse, zumindest einen Phasenkontakt zum Anschließen an jeweils einen Außenleiter sowie zumindest einen Messsensor zum Erfassen zumindest einer dem jeweiligen Außenleiter zuzurechnenden Messgröße umfasst, und wobei vorteilhaft für jeden Phasenkontakt jeweils zumindest ein Funktionsindikator vorgesehen ist, wobei der jeweilige zumindest eine Funktionsindikator am Modulgehäuse angeordnet ist, und wobei das Messmodul dazu eingerichtet ist, den jeweiligen zumindest einen Funktionsindikator in Abhängigkeit von der zumindest einen erfassten Messgröße anzusteuern.

Beispielsweise kann ein solches Messmodul oder können mehrere Messmodule mit einem Lasttrennschalter in einem Messsystem zusammenwirken, wobei der Lasttrennschalter üblicherweise ein Schaltergehäuse, zumindest eine Phasenklemme zum Anschließen an jeweils einen Außenleiter sowie zumindest eine Schalterklemme zum Anschließen an jeweils eine weiterführende Leitung aufweist und dazu eingerichtet ist, eine elektrische Verbindung zwischen der zumindest einen Phasenklemme und der zumindest einen Schalterklemme wahlweise ein- oder auszuschalten. Der zumindest eine Phasenkontakt des Messmoduls kann komplementär zur zumindest einen Phasenklemme und/oder zur zumindest einen Schalterklemme des Lasttrennschalters geformt sein, um in der zumindest einen Phasenklemme oder Schalterklemme des Lasttrennschalters mitgeklemmt werden zu können.

Mit dem Begriff "Kommunikationsmodul" wird hier ein Modul bezeichnet, welches signaltechnisch mittels eines, insbesondere drahtlosen, Kommunikationskanals mit zumindest einem Messmodul gekoppelt ist, wobei das zumindest eine Messmodul eine Schnittstelle zur Übergabe von zumindest einem Messsensor erfassten digitalen Messdaten an das Kommunikationsmodul aufweist, und wobei das Kommunikationsmodul einen Datenspeicher zum Speichern der digitalen Messdaten aufweist.

Die Schnittstelle des zumindest einen Messmoduls kann neben der Datenübertragung der erfassten Messdaten vom zumindest einen Messmodul an das Kommunikationsmodul weiters auch als Datenschnittstelle für ein externes mobiles Endgerät dienen. Für den Ausführungsfall, dass das Messmodul mit einer Funk-Schnittstelle, beispielsweise einer Bluetooth- oder ZigBee-tauglichen Funk-Schnittstelle ausgerüstet ist, kann eine Kommunikation bzw. Datenübertragung zwischen dem Messmodul und einem externen mobilen Endgerät mittels Funksignalen beispielsweise via Bluetooth erfolgen, sofern das verwendete Endgerät mit einer entsprechend geeigneten Software ausgestattet ist.

Für den Ausführungsfall, dass die Kommunikation bzw. Datenübertragung zwischen dem Messmodul und einem externen mobilen Endgerät web- und/oder internet-basiert erfolgen soll, kann das Kommunikationsmodul zweckmäßigerweise als Gateway ausgerüstet sein. In diesem Falle kann auch ein Webserver implementiert sein. Ein Benutzer kann dann beispielsweise internet-basiert via eines Webbrowser-Zugangs von einem mobilen Endgerät aus Details zu den erfassten digitalen Messdaten auslesen und Geräteparameter des Messmoduls überprüfen und diese gegebenenfalls verändern bzw. parametrieren.

Ebenso kann das Kommunikationsmodul eine oder mehrere Datenschnittstellen beispielsweise für ein externes mobiles Endgerät und/oder für stationäre Endgeräte, Standrechner, Netzwerkrechner und dergleichen aufweisen, mit dem ein Benutzer beispielsweise internet-basiert via eines Webbrowser-Zugangs von einem mobilen Endgerät oder einem Netzwerkrechner aus die im Datenspeicher des Kommunikationsmoduls gespeicherten digitalen Messdaten auslesen kann und/oder über den Kommunikationskanal Details zu den erfassten digitalen Messdaten auslesen kann und Geräteparameter des Messmoduls überprüfen und gegebenenfalls verändern bzw. parametrieren kann.

In einer Weiterbildung der Erfindung kann das Kommunikationsmodul beispielsweise auch ein Anzeigendisplay zur Visualisierung der Messdaten aufweisen.

Besonders zweckmäßig kann es sein, wenn das Kommunikationsmodul ein mobiles Endgerät, vorzugsweise ein Smartphone und/oder einen Notebook-Rechner, umfasst oder ein mobiles Endgerät ist.

Je nach Anwendungsfall kann es vorteilhaft sein, wenn bei einem erfindungsgemäßen Modul das Messmodul sowie das Kommunikationsmodul in kompakter Bauweise in einem gemeinsamen Modulgehäuse integriert sind.

Das Messmodul und das Kommunikationsmodul kommunizieren üblicherweise signaltechnisch in einem Nahbereich miteinander, da die einzelnen Module beispielsweise im selben Schaltschrank eines Niederspannungsverteilers montiert sind. Im Falle einer Geräteintegration des Messmoduls und des Kommunikationsmoduls in einem gemeinsamen Modulgehäuse kann anstelle eines drahtlosen Kommunikationskanals für den Datentransfer zwischen den einzelnen Moduleinheiten auch ein drahtgebundener Kommunikationskanal für den Datentransfer realisiert sein. Beispielsweise können entsprechende komplementäre bzw. zueinander korrespondierende Stecker-/ Steckbuchsen-Verbindungen in den koppelbaren bzw. zusammensteckbaren Gehäusen für die Herstellung eines drahtgebundenen Kommunikationskanals dienen.

Alternativ dazu können die einzelnen unterschiedlichen Moduleinheiten auf jeweils starren Leiterplattenabschnitten eines Leiterplattenverbundes angeordnet sein und mit dazwischenliegenden flexiblen Leiterplattenabschnitten störungssicher miteinander verbunden sein.

Besonders einfach lässt sich ein erfindungsgemäßes Modul an einer Tragschiene in einem Schaltschrank befestigen, wenn das Modulgehäuse als Tragschienengehäuse, vorzugsweise als Hutschienengehäuse, ausgebildet ist.

Im Rahmen der Erfindung wird auch ein Schaltschrank angegeben, insbesondere ein Schaltschrank eines Niederspannungsverteilers, wobei im Schaltschrank zumindest ein erfindungsgemäßes Modul nach einem der Ansprüche 1 bis 12 angeordnet ist.

### KURZE BESCHREIBUNG DER FIGUREN

Die Erfindung wird nun anhand von Ausführungsbeispielen näher erläutert. Die Zeichnungen sind beispielhaft und sollen den Erfindungsgedanken zwar darlegen, ihn aber keinesfalls einengen oder gar abschließend wiedergeben.

Dabei zeigen:
- **Fig. 1**: in einer isometrischen Ansicht schräg von vorne ein Modul
- fällt,: gemäß einem Beispiel, welches nicht unter den Schutzumfang mit einem Modulgehäuse;
- **Fig. 2**: in einer isometrischen Ansicht schräg von vorne eine aus dem Stand der Technik bekannte, herkömmliche Doppelstock-Leiterplatte mit einer Stiftleistenverbindung;
- **Fig. 3**: in einer Ansicht von oben einen ersten Leiterplattenverbund gemäß einem Beispiel, welches nicht unter den Schutzumfang fällt;
- **Fig. 4**: in einer Ansicht von oben einen zweiten Leiterplattenverbund gemäß einem Beispiel, welches nicht unter den Schutzumfang fällt;
- **Fig. 5**: in einer Ansicht von oben einen dritten Leiterplattenverbund gemäß einem Beispiel, welches nicht unter den Schutzumfang fällt;
- **Fig. 6**: in einer isometrischen Ansicht schräg von der Seite einen vierten Leiterplattenverbund gemäß der Erfindung, der als dreidimensionale räumliche Struktur gefaltet ist;
- **Fig. 7**: in einer isometrischen Ansicht schräg von der Seite den in Fig. 6 dargestellten Leiterplattenverbund nach Bestückung mit elektronischen Bauteilen;
- **Fig. 8**: in einer Explosionsdarstellung den in Fig. 6 dargestellten Leiterplattenverbund vor dem Einsetzen in einen Innenraum eines Modulgehäuses eines Moduls gemäß der Erfindung;
- **Fig. 9**: in einer Explosionsdarstellung den in Fig. 7 dargestellten, bereits mit elektronischen Bauteilen bestückten Leiterplattenverbund vor dem Einsetzen in einen Innenraum eines Modulgehäuses eines Moduls gemäß der Erfindung;
- **Fig. 10**: in einer Explosionsdarstellung einen fünften Leiterplattenverbund gemäß der Erfindung, der als dreidimensionale räumliche Struktur gefaltet ist, vor dem Einsetzen in einen Innenraum eines Modulgehäuses eines Moduls gemäß der Erfindung;
- **Fig. 11**: in einer Detailansicht die Oberseite des in Fig. 6 gezeigten Leiterplattenverbunds mit einer formschlüssigen sowie elektrisch leitenden Verbindung zweier starrer Leiterplattenabschnitte zum Fixieren der Einbaulage des Leiterplattenverbunds als dreidimensionale Struktur;
- **Fig. 12**: den in Fig. 11 dargestellten Leiterplattenverbund in einer isometrischen Ansicht schräg von der Seite.

### WEGE ZUR AUSFÜHRUNG DER ERFINDUNG

Im Folgenden werden für funktionsgleiche oder vergleichbare Bauteile bzw. Komponenten jeweils dieselben Bezugszeichen verwendet. Die im Folgenden verwendeten Positionsangaben von Bauteilen oder Komponenten, wie beispielsweise die Begriffe "oben", "unten", "oberhalb", "unterhalb", "vorne", "hinten", "seitlich", "innerhalb", "außerhalb", und dergleichen, dienen im Wesentlichen dem besseren Verständnis der Erfindung, insbesondere in Verbindung mit den nachfolgenden Zeichnungen. Die verwendeten Positionsangaben können sich möglicherweise auf bestimmte Einbaulagen oder auf einzelnen Ansichten in den Figuren beziehen. In jedem Fall sind solche Positionsangaben dem Fachmann geläufig, schränken die vorliegende Erfindung aber nicht ein.

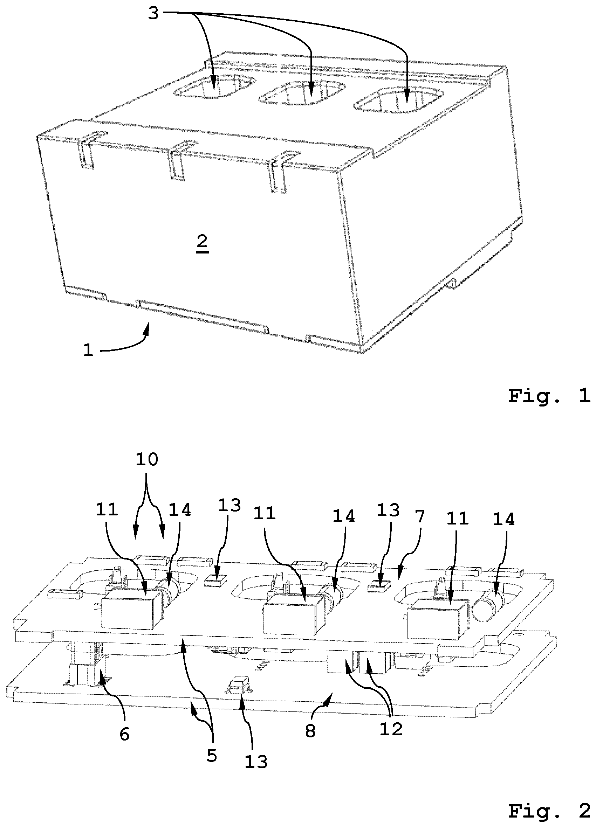

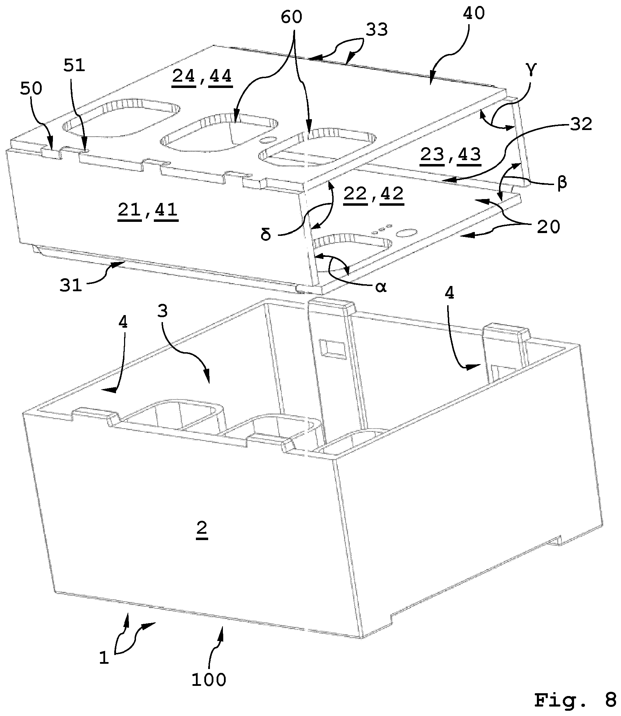

**Fig. 1** zeigt ein Modul 1 gemäß einem Beispiel, welches nicht unter den Schutzumfang fällt, mit einem Modulgehäuse 2 sowie mit einem Innenraum 3. Das Modulgehäuse 2 ist hier geschlossen dargestellt, weshalb der Innenraum 3 sowie die entsprechenden Innenwandungen des Modulgehäuses 2 in dieser Ansicht nicht eingesehen werden können. In Fig. 8 ist ein vergleichbares Modul 1 mit einem Modulgehäuse 2 mit abgenommenem Gehäusedeckel veranschaulicht.

**Fig. 2** zeigt eine aus dem Stand der Technik bekannte, herkömmliche Doppelstock-Leiterplatte 5 mit einer herkömmlichen Steckerverbindung in Form einer Stiftleistenverbindung 6. Zwei herkömmliche Leiterplatten 5 sind hier aus Platzgründen stockweise übereinander angeordnet und mit darauf befestigten Stiftleistenverbindungen 6 doppelstöckig zusammengesteckt. Elektronische Leiterbahnen der ersten Leiterplatte 7 sind mittels der mechanischen Stecker der Stiftleistenverbindungen 6 mit elektronischen Leiterbahnen der zweiten Leiterplatte 8 signalleitend elektrisch leitend verbunden. Nachteilig an dieser herkömmlichen Ausführung ist, dass die Steckerverbindungen bzw. Stiftleistenverbindungen 6 zwischen zwei oder mehreren konventionellen, starren Leiterplatten 7, 8 aufwändig in der Fertigung und zudem fehleranfällig hinsichtlich der Signalübertragung sind. Infolge mechanischer und insbesondere thermischer Belastungen können Lötstellen zur Kontaktierung der Stiftleistenverbindungen 6 an den jeweiligen Leiterplatten 5,7,8 beschädigt und so die Signalübertragung zwischen den zwei oder mehreren mit Steckerverbindungen verbundenen Leiterplatten 5,7,8 gestört werden.

Weiters ist von Nachteil beim Einsatz einer in Fig. 2 gezeigten herkömmlichen Doppelstock-Leiterplatte 5 im Zusammenhang mit einem gattungsgemäßen Modul, dass die darauf befestigten elektronischen Komponenten bzw. elektronischen Bauteile 10 meist nahe beieinander positioniert sind. So befinden sich beispielsweise wärmeerzeugende elektronische Bauteile 11, die im laufenden Betrieb heiß werden und Abwärme produzieren, wie beispielsweise ein oder mehrere Netzteile 12, auf derselben Leiterplatte 7,8 oder zumindest in räumlicher Nähe mit anderen elektronischen Bauteilen 10 bzw. elektronischen Komponenten wie beispielsweise Microcontroller oder Halbleiterchips 13, also mit temperaturempfindlichen elektronischen Bauteilen 14, was nachteilig ist. Elektronische Bauteile 11,12 eines solchen Moduls, die sich im Betrieb stark erwärmen und Abwärme abgeben, haben negative Auswirkungen auf die beispielsweise für eine exakte Temperaturmessung erforderlichen, temperaturempfindlichen elektronischen Bauteile 13,14, Leiterbahnen und/oder Einzellagen einer Leiterplatte 5. Aufgrund der unerwünschten Wärmeleitung und/oder Wärmestrahlung der wärmeerzeugenden elektronischen Bauteile 11,12 wird eine exakte Temperaturmessung negativ beeinflusst bzw. gestört.

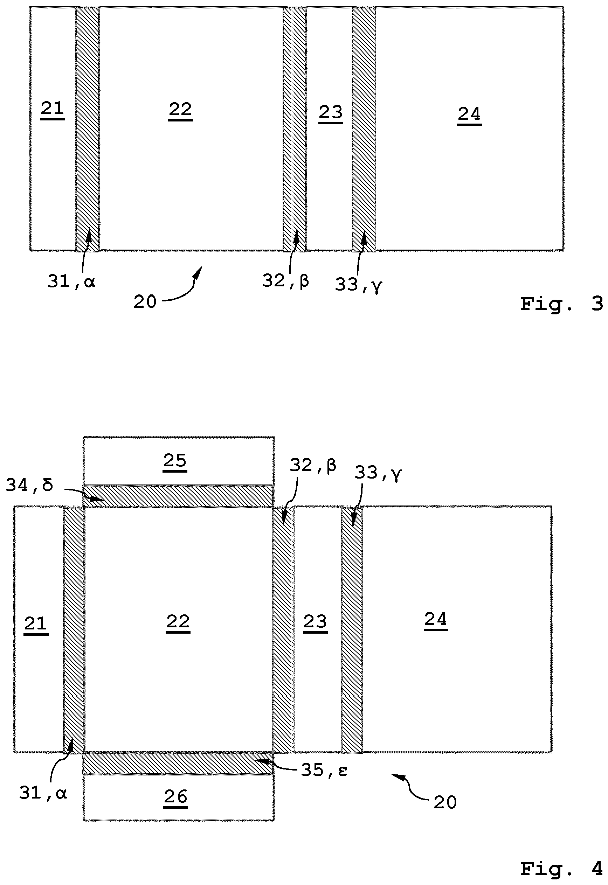

**Fig. 3** zeigt in einer Draufsicht einen ersten, abschnittsweise flexiblen Leiterplattenverbund 20 gemäß einem Beispiel, welches nicht unter den Schutzumfang fällt, wie er für den Einsatz in einem Modulgehäuse eines gattungsgemäßen Moduls vorgesehen ist. Hier sind ein erster starrer Leiterplattenabschnitt 21, ein zweiter starrer Leiterplattenabschnitt 22, ein dritter starrer Leiterplattenabschnitt 23 sowie ein vierter starrer Leiterplattenabschnitt 24 jeweils mittels dazwischenliegender flexibler Leiterplattenabschnitte 31, 32, 33 signalleitend elektrisch miteinander verbunden. Der erste flexible Leiterplattenabschnitt 31 verbindet den ersten starren Leiterplattenabschnitt 21 und den zweiten starren Leiterplattenabschnitt 22 miteinander. Der zweite flexible Leiterplattenabschnitt 32 verbindet den zweiten starren Leiterplattenabschnitt 22 und den dritten starren Leiterplattenabschnitt 23 miteinander. Der dritte flexible Leiterplattenabschnitt 33 verbindet den dritten starren Leiterplattenabschnitt 23 und den vierten starren Leiterplattenabschnitt 24 miteinander.

Die in Fig. 3 in der Draufsicht flach in einer Ebene dargestellten starren Leiterplattenabschnitte 21,22,23,24 des Leiterplattenverbunds 20 können in Einbaulage innerhalb eines hier nicht gezeigten Modulgehäuses zu einer dreidimensionalen, räumlichen Struktur gefaltet bzw. zusammengesteckt werden, um den verfügbaren Innenraum innerhalb des entsprechenden Modulgehäuses bestmöglich ausnutzen zu können. Die flexiblen Leiterplattenabschnitte 31,32,33 sind hier beispielsweise aus einem flexiblen Polyimid-Folienmaterial hergestellt und ermöglichen die Bildung einer besonders flexiblen, dreidimensionalen Struktur des Leiterplattenverbunds 20 in Einbaulage innerhalb des Modulgehäuses, wobei jeweils zwei benachbarte starre Leiterplattenabschnitte 21,22,23,24 zueinander gleiche oder unterschiedliche Winkel α,β,γ beispielsweise in einem Bereich von 10° bis 170° einschließen können. Oder in anderen Worten können der erste flexible Leiterplattenabschnitt 31 in einem ersten Winkel α, der zweite flexible Leiterplattenabschnitt 32 in einem zweiten Winkel β, sowie der dritte flexible Leiterplattenabschnitt 33 in einem dritten Winkel γ gebogen bzw. gefaltet werden, um eine räumliche dreidimensionale Struktur der starren Leiterplattenabschnitte 21,22,23,24 des Leiterplattenverbunds 20 zu ermöglichen. Hier in Fig. 3 sind die Abschnitte des Leiterplattenverbunds 20 jeweils plan in einer Ebene dargestellt. Die Winkel α, β und γ zwischen den jeweils paarweise benachbarten starren Leiterplattenabschnitten 21,22; 22,23 bzw. 23,24 betragen somit jeweils 180°.

Durch die mehreren bzw. hier vier miteinander signalleitend verbundenen starren Leiterplattenabschnitte 21,22,23,24 wird die verfügbare Leiterplattenfläche zum Bestücken mit elektronischen Bauteilen vergrößert. Insbesondere bei möglicher beidseitiger Bestückung einer oder mehrerer der starren Leiterplattenabschnitte 21,22,23,24 wird mit einem Leiterplattenverbund 2C eine besonders vorteilhafte Möglichkeit geboten, um im Betrieb wärmeerzeugende elektronische Bauteile von temperaturempfindlichen elektronischen Bauteilen, die beispielsweise für hochpräzise Temperarturmessungen erforderlich sind, in ihren Positionen am Leiterplattenverbund 20 räumlich möglichst weit voneinander zu trennen bzw. zu entflechten. Unerwünschte Beeinträchtigungen aufgrund von Wärmeleitung und/oder Wärmestrahlung zwischen den wärmeerzeugenden elektronischen Bauteilen und jenen temperaturempfindlichen elektronischen Bauteilen, die nicht heiß werden sollen, lassen sich im laufenden Betrieb eines gattungsgemäßen Moduls, das mit einem solchen Leiterplattenverbund 20 ausgestattet ist, vorteilhaft vermeiden.

**Fig. 4** zeigt in einer Draufsicht von oben einen zweiten Leiterplattenverbund 20 gemäß einem Beispiel, welches nicht unter den Schutzumfang fällt. Hier sind insgesamt sechs starre Leiterplattenabschnitte 21,22,23,24,25,26 mittels insgesamt fünf jeweils dazwischenliegenden, flexiblen Leiterplattenabschnitten 31,32,33,34,35 signalleitend elektrisch miteinander verbunden. Die hier gezeigte Anordnung der sechs starren Leiterplattenabschnitte 21,22,23,24,25,26 entspricht einem Quadernetz und kann besonders zweckmäßig in einem hier nicht gezeigten, quaderförmigen Modulgehäuse eines Moduls positioniert werden.

Die flexiblen Leiterplattenabschnitte 31,32,33,34,45 sind hier beispielsweise aus einem flexiblen Polyimid-Folienmaterial hergestellt und ermöglichen die Bildung einer besonders flexiblen, dreidimensionale Struktur des Leiterplattenverbunds 20 in Einbaulage innerhalb eines Modulgehäuses, wobei jeweils zwei benachbarte starre Leiterplattenabschnitte 21,22,23,24,25,26 zueinander einen Winkel α, β,γ,δ,ε beispielsweise in einem Bereich von 10° bis 170° einschließen können. Je nach Geometrie des Modulgehäuses können die Winkel α,β,γ,δ,ε jeweils gleich groß oder unterschiedlich groß sein. Im Falle eines quaderförmigen Modulgehäuses werden die Winkel α, β,γ,δ,ε zwischen den benachbarten starren Leiterplattenabschnitten 21,22,23,24,25,26 in Einbaulage zweckmäßiger Weise jeweils im Wesentlichen gleich groß gewählt, wobei diese insbesondere jeweils 90° betragen.

Die hier in der Draufsicht flach in einer Ebene dargestellten starren Leiterplattenabschnitte 21,22,23,24,25,26 des Leiterplattenverbunds 20 können in Einbaulage innerhalb eines hier nicht gezeigten, vorzugsweise quaderförmigen Modulgehäuses zu einer dreidimensionalen, räumlichen quaderförmigen Struktur gefaltet bzw. zusammengesteckt werden, um den verfügbaren Innenraum innerhalb eines solchen Modulgehäuses bestmöglich ausnutzen zu können. Durch die hier sechs miteinander signalleitend verbundenen starren Leiterplattenabschnitte 21,22,23,24,25,26 wird die verfügbare Leiterplattenfläche zum Bestücken mit elektronischen Bauteilen weiter vergrößert.

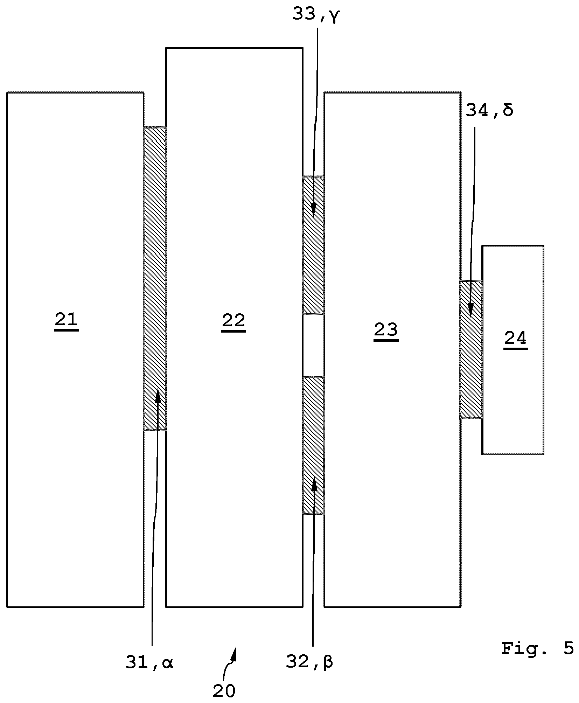

**Fig. 5** zeigt in einer Ansicht von oben einen dritten Leiterplattenverbund 20 gemäß einem Beispiel, welches nicht unter den Schutzumfang fällt, mit insgesamt vier miteinander verbundenen starren Leiterplattenabschnitten 21,22,23,24. Es wird dazu auf die vorige Beschreibung zu den Figuren 3 und 4 verwiesen. Zwischen einem zweiten 22 und einem dritten 23 starren Leiterplattenabschnitt sind hier zwei flexible Leiterplattenabschnitte, nämlich ein zweiter 32 und ein dritter 33 flexibler Leiterplattenabschnitt, vorgesehen, die jeweils den zweiten starren Leiterplattenabschnitt 22 und den dritten starren Leiterplattenabschnitt 23 signalleitend elektrisch miteinander verbinden. In Einbaulage innerhalb eines Modulgehäuses kann dieser Leiterplattenverbund 20 so räumlich strukturiert werden, dass der zweite starre Leiterplattenabschnitt 22 und der dritte starre Leiterplattenabschnitt 23 zueinander einen Winkel einschließen. In diesem Falle werden der zweite flexible Leiterplattenabschnitt 32 und der dritte flexible Leiterplattenabschnitt 33 jeweils um denselben Winkel zueinander gefaltet bzw. gebogen. Der zweite Winkel β des zweiten flexiblen Leiterplattenabschnitts 32 sowie der dritten Winkel γ des dritten flexiblen Leiterplattenabschnitts 33 sind in diesem Fall in räumlich strukturierter Einbaulage des Leiterplattenverbunds 20 also gleich groß.

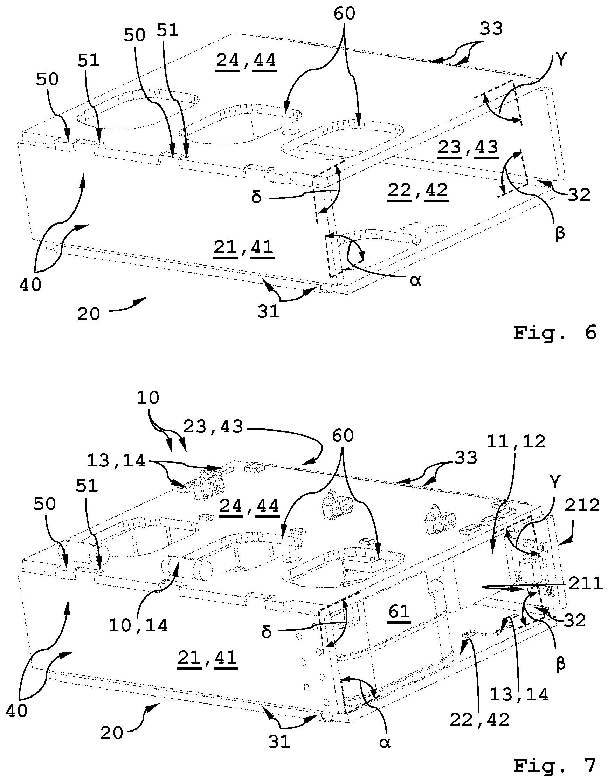

**Fig. 6** zeigt in einer isometrischen Ansicht schräg von der Seite einen vierten Leiterplattenverbund 20 gemäß der Erfindung, der als dreidimensionale räumliche Struktur 40 gefaltet ist. Der hier dargestellte Leiterplattenverbund 20 umfasst vier starre Leiterplattenabschnitte 21,22,23,24 sowie drei flexible Leiterplattenabschnitte 31,32,33, wobei jeweils ein erster flexibler Leiterplattenabschnitt 31 zwischen dem ersten 21 und dem zweiten 22 starren Leiterplattenabschnitt, ein zweiter flexibler Leiterplattenabschnitt 32 zwischen dem zweiten 22 und dem dritten 23 starren Leiterplattenabschnitt, sowie ein dritter flexibler Leiterplattenabschnitt 33 zwischen dem dritten 23 und dem vierten 24 starren Leiterplattenabschnitt angeordnet sind. Die flexiblen Leiterplattenabschnitte 31,32,33 dienen jeweils zur signalleitenden elektrischen Verbindung der jeweils angrenzenden starren Leiterplattenabschnitte 21,22,23,24.

Die flexiblen Leiterplattenabschnitte 31,32,33 sind hier beispielsweise als Polyimid-Flexleiterplatten, also als flexible Polyimid-Folienträger mit darauf angeordneten Leiterbahnen, ausgeführt. Die starren Leiterplattenabschnitte 21,22,23,24 sind hier beispielsweise als mehrlagig laminierte PCB-Leiterplatten aus FR4-Material hergestellt.

Der Leiterplattenverbund 20 ist in Fig. 6 bereits als dreidimensionale Struktur 40 gefaltet, wobei die starren Leiterplattenabschnitte 21,22,23,24 paarweise jeweils einen Winkel zueinander einschließen. So schließen der erste starre Leiterplattenabschnitt 21 und der zweite starre Leiterplattenabschnitt 22 zueinander einen ersten Winkel α ein. Der zweite starre Leiterplattenabschnitt 22 und der dritte starre Leiterplattenabschnitt 23 schließen zueinander einen zweiten Winkel β ein. Der dritte starre Leiterplattenabschnitt 23 und der vierte starre Leiterplattenabschnitt 24 schließen zueinander einen dritten Winkel γ ein. Der erste Winkel α, der zweite Winkel β sowie der dritte Winkel γ zwischen den jeweils angrenzenden starren Leiterplattenabschnitten 21,22,23 entsprechen in Einbaulage der dreidimensionalen Struktur 40 jeweils dem Biegewinkel der dazwischenliegenden flexiblen Leiterplattenabschnitte 31,32,33.

Der vierte starre Leiterplattenabschnitt 24 schließt mit dem ersten starren Leiterplattenabschnitt 21 einen vierten Winkel δ ein. Anstelle eines flexiblen Leiterplattenabschnitts sind die beiden starren Leiterplattenabschnitte 21 und 24 an ihren Rändern mit einer formschlüssigen Verbindung in Form einer Spundung mit mehreren Rastnasen 50 und dazu komplementären Rastnuten 51, in die die Rastnasen 50 eingreifen, zusammengesteckt. Um zusätzlich auch die mechanische Stabilität des Leiterplattenverbunds 20 in Einbaulage zu erhöhen und ein unerwünschtes Lösen der zusammengesteckten starren Leiterplattenabschnitte 21,24 zu verhindern, sind die miteinander zusammengesteckten Rastnasen 50 bzw. Rastnuten 51 zusätzlich auch mittels Lötverbindungen stoffschlüssig miteinander verbunden.

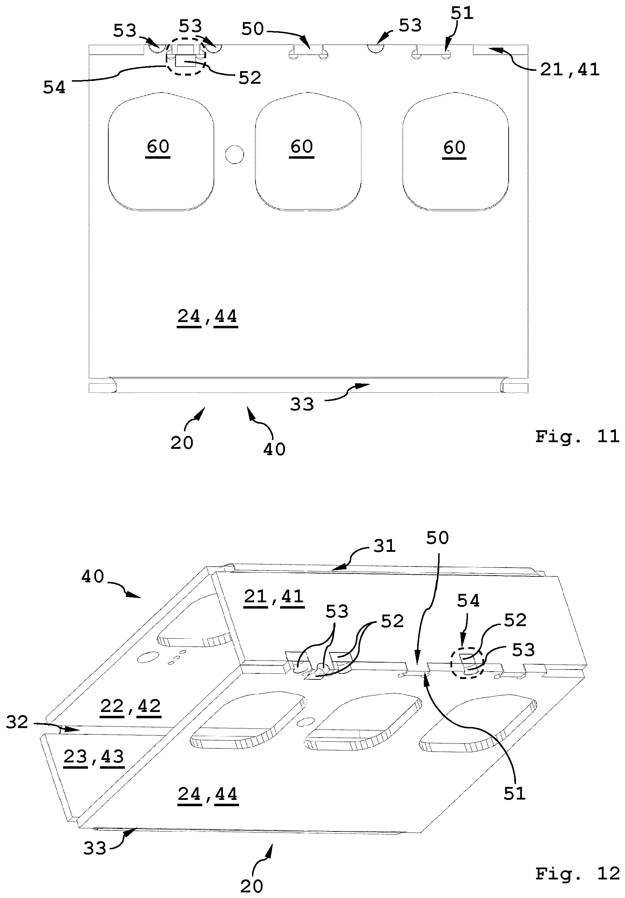

Die Lötverbindungen können dabei gegebenenfalls so angeordnet werden, dass sie nicht nur ein unbeabsichtigtes Öffnen der Steckverbindung der starren Leiterplattenabschnitte 21,24 verhindern, sondern zusätzlich auch signalleitende elektrische Verbindungen zwischen den beiden zusammengesteckten starren Leiterplattenabschnitten 21,24 erzielt werden. Dazu können entsprechende Leiterbahnen bzw. Kontakte an den einander berührenden Rändern der starren Leiterplattenabschnitte 21,24 miteinander verlötet werden. Im Detail wird dazu auf die nachfolgende Beschreibung zu den Figuren 11 und 12 verwiesen.

Jeder starre Leiterplattenabschnitt 21,22,23,24 der dreidimensionalen Struktur 40 bildet in zusammengefügter Einbaulage eine eigene Ebene 41,42,43,44. Der erste starre Leiterplattenabschnitt 21 bildet in Fig. 6 eine erste, vordere Ebene 41 der gezeigten räumlichen Struktur 40. Der zweite starre Leiterplattenabschnitt 22 bildet eine zweite, untere Ebene 42 der gezeigten räumlichen Struktur 40. Der dritte starre Leiterplattenabschnitt 23 bildet eine dritte, hintere Ebene 43 der gezeigten räumlichen Struktur 40. Der vierte starre Leiterplattenabschnitt 24 bildet eine vierte, obere Ebene 44 der gezeigten räumlichen Struktur 40. Die starren Leiterplattenabschnitte 21,22,23,24 bzw. die dadurch gebildeten Ebenen 41,42,43,44 stehen jeweils im Wesentlichen normal aufeinander. Die Winkel α,β,γ,δ betragen hier jeweils etwa 90°.

Der obere starre Leiterplattenabschnitt 24 sowie der untere starre Leiterplattenabschnitt 22 weisen jeweils drei deckungsgleiche Ausnehmungen 60 für Strommesssensoren auf. Strommesssensoren bzw. Stromwandler sind elektrische Bauelemente, mit denen die Stromstärke in Kabeln und Stromschienen galvanisch getrennt - und damit berührungslos - anhand der durch elektrische Ströme ausgelösten magnetischen Flussdichte gemessen werden kann. Der in Fig. 6 veranschaulichte Leiterplattenverbund 20 ist zur besseren Übersicht noch vor der Bestückung mit elektronischen Bauteilen gezeigt.

**Fig. 7** zeigt den in Fig. 6 dargestellten Leiterplattenverbund 20 nach Bestückung mit elektronischen Bauteilen 10. Aufgrund der großen Bestückungsfläche, die der Leiterplattenverbund 20 bietet, können im Betrieb wärmeerzeugende elektronische Bauteile 11 wie beispielsweise ein oder mehrere Netzteile 12 von Microcontrollern, Halbleiterchips 13 und/oder weiteren temperaturempfindlichen elektronischen Bauteilen 14 räumlich getrennt werden. Die insgesamt zur Verfügung stehende Bestückungsfläche des Leiterplattenverbunds 20 kann noch weiter vergrößert werden, wenn zumindest ein starrer Leiterplattenabschnitt 23 beidseitig, also an seiner ersten Außenseite 211 sowie an seiner gegenüberliegenden zweiten Außenseite 212, mit elektronischen Bauteilen 10 bestückt ist.

Wie bereits vorhin zu Fig. 6 beschrieben, sind in Fig. 7 die beiden starren Leiterplattenabschnitte 21 und 24 an ihren Rändern mit einer formschlüssigen Verbindung in Form einer Spundung mit mehreren Rastnasen 50 und dazu komplementären Rastnuten 51, in die die Rastnasen 50 eingreifen, zusammengesteckt. Um zusätzlich die Steckverbindungen zu stabilisieren und ein unbeabsichtigtes Lösen der Steckverbindungen zu verhindern, und gegebenenfalls zusätzlich auch signalleitende elektrische Verbindungen zwischen den beiden zusammengesteckten starren Leiterplattenabschnitten 21,24 zu erzielen, sind entsprechende Leiterbahnen bzw. Kontakte an den einander berührenden Rändern der starren Leiterplattenabschnitte 21,24 beispielsweise miteinander verlötet. Im Detail wird dazu auf die nachfolgende Beschreibung zu den Figuren 11 und 12 verwiesen.

In Fig. 7 ist weiters ein Gehäuse eines Strommesssensors 61 skizziert, der im Bereich der Ausnehmung 60 angeordnet ist. Am Leiterplattenverbund 20 sind hier mehrere Messsensoren vorgesehen, wobei beispielsweise drei baugleiche Strommesssensoren 61 vorgesehen sind, die jeweils im Bereich der drei Ausnehmungen 60 angeordnet sind. Die Strommesssensoren 61 dienen zum Erfassen der Stromstärke in einem jeweiligen Außenleiter einer Stromleitung.

**Fig. 8** zeigt in einer Explosionsdarstellung den in Fig. 6 dargestellten, zu einer dreidimensionalen Struktur 40 gefalteten, dritten Leiterplattenverbund 20 vor dem Bestücken mit elektronischen Bauteilen sowie vor dem Einsetzen in einen Innenraum 3 eines Modulgehäuses 2 eines Moduls 1 gemäß der Erfindung. Bei dem Modul 1 handelt es sich hier um ein Messmodul 100. In Einbaulage grenzt die dreidimensionale Struktur 40 des Leiterplattenverbunds 20 möglichst nahe an die Innenwandungen 4 des Modulgehäuses 2, wobei der verfügbare Innenraum 3 des Modulgehäuses 2 bestmöglich ausgenützt wird. Gegebenenfalls kann das Modulgehäuse 2 nach Einsetzen des Leiterplattenverbunds 20 mit einem in Fig. 8 nicht gezeigten Gehäusedeckel verschlossen werden. Es wird dazu auf die Fig. 1 verwiesen.

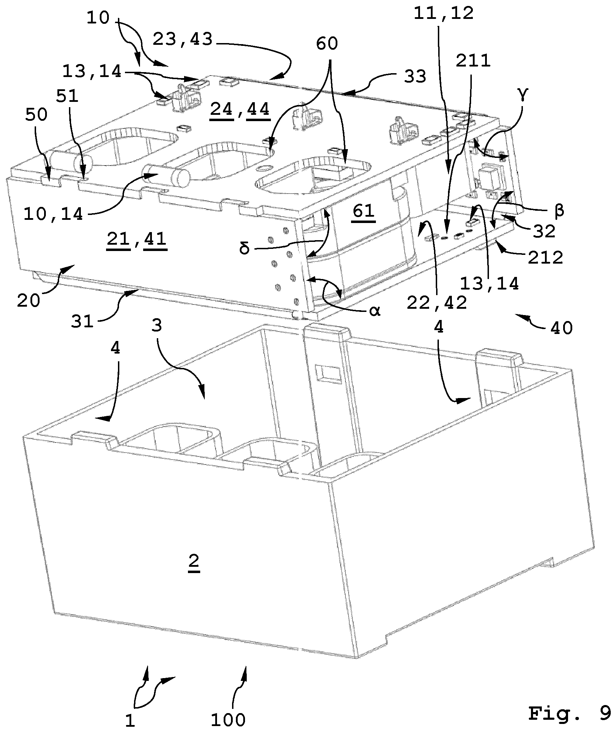

**Fig. 9** veranschaulicht - vergleichbar mit Fig. 8 - in einer Explosionsdarstellung den in Fig. 7 dargestellten, bereits mit elektronischen Bauteilen 10,11,12,13,14 bestückten Leiterplattenverbund 20 vor dem Einsetzen in einen Innenraum 3 eines Modulgehäuses 2 eines Moduls 1 gemäß der Erfindung. Bei dem Modul 1 handelt es sich hier um ein Messmodul 100, das insbesondere zur Strommessung mit drei Strommesssensoren 61 ausgestattet ist. Das mit einem Gehäusedeckel bereits verschlossene Modulgehäuse 2 des Moduls 1 mit innenliegendem Leiterplattenverbund 20 ist in Fig. 1 gezeigt.

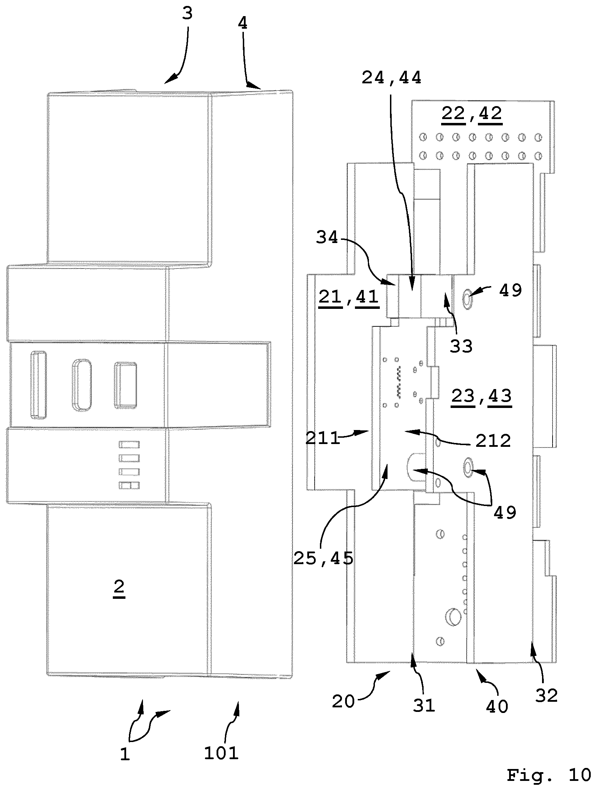

**Fig. 10** zeigt in einer Explosionsdarstellung einen fünften Leiterplattenverbund 20 gemäß der Erfindung, der als dreidimensionale räumliche Struktur 40 gefaltet ist, vor dem Einsetzen in einen Innenraum 3 eines Modulgehäuses 2 eines Moduls 1 gemäß der Erfindung. Bei diesem Modul 1 handelt es sich beispielsweise um ein Kommunikationsmodul 101. Der gezeigte Leiterplattenverbund 20 umfasst hier insgesamt fünf starre Leiterplattenabschnitte 21,22,23,24,25, die jeweils mit paarweise dazwischenliegenden flexiblen Leiterplattenabschnitten 31,32,33,34 miteinander signalleitend elektrisch verbunden sind. Die starren Leiterplattenabschnitte 21,23 und 25 sind hier jeweils im Wesentlichen parallel zueinander angeordnet und bilden eine erste Ebene 41, eine dritte Ebene 43 sowie eine fünfte Ebene 45 der räumlichen Struktur 40 des Leiterplattenverbunds 20. Die zwischen dem ersten starren Leiterplattenabschnitt 21 und dem dritten starren Leiterplattenabschnitt 43 angeordnete zweite starre Leiterplattenabschnitt 22, der mittels der flexiblen Leiterplattenabschnitte 31 und 32 mit den benachbarten starren Leiterplattenabschnitten 21,23 verbunden ist, bildet hier die Rückseite bzw. Unterseite des Leiterplattenverbunds 20. Der erste, dritte und fünfte starre Leiterplattenabschnitt 21,23,25 schließt jeweils einen Winkel von etwa 90° mit dem darunterliegenden zweiten starren Leiterplattenabschnitt 22 bzw. mit einer durch diesen zweiten starren Leiterplattenabschnitt 22 gebildeten zweiten Ebene 42 der Struktur 40 ein. Der fünfte starre Leiterplattenabschnitt 45 ist hier mittels eines dazwischenliegenden vierten starren Leiterplattenabschnitts 24 sowie mittels zweier flexibler Leiterplattenabschnitte 33,34 mit dem dritten Leiterplattenabschnitt 43 signalleitend elektrisch verbunden. Der vierte starre Leiterplattenabschnitt 24 bildet hier eine vierte Ebene 44 der Struktur 40, die im Wesentlichen parallel zur zweiten Ebene 42 bzw. zum zweiten starren Leiterplattenabschnitt 22 angeordnet ist. Die Winkel zwischen jeweils zwei benachbarten starren Leiterplattenabschnitten 21,22,23,24,25 betragen hier jeweils im Wesentlichen 90°. Die starren Leiterplattenabschnitte 21,23,24,25 sind mittels Abstandhaltern 49 mechanisch miteinander verbunden.

Vorteilhaft können die starren Leiterplattenabschnitte, insbesondere kann der zentral angeordnete fünfte starre Leiterplattenabschnitt 25, beidseitig an den jeweils gegenüberliegenden Außenseiten 211,212 mit elektronischen Bauteilen bestückt werden. Der Leiterplattenverbund 20 stellt damit eine sehr große bestückbare Leiterplattenfläche zur Verfügung und bittet aufgrund der räumlichen Struktur 40 auch ausreichend Platz, um im Betrieb wärmeerzeugende elektronische Bauteile von temperaturempfindlichen elektronischen Bauteilen räumlich zu trennen. Der in Fig. 10 gezeigte Leiterplattenverbund 20 ist der besseren Übersicht wegen noch nicht mit elektronischen Bauteilen bestückt.

Alternativ kann der vierte starre Leiterplattenabschnitt 24 auch fehlen bzw. gemeinsam mit den angrenzenden flexiblen Leiterplattenabschnitten 33,34 einen Teil eines durchgehenden, einteiligen flexiblen Leiterplattenabschnitts zwischen den starren Leiterplattenabschnitten 23 und 25 bilden.

**Fig. 11** stellt in einer Detailansicht die Oberseite des in Fig. 6 gezeigten Leiterplattenverbunds 20 gemäß der Erfindung mit einer formschlüssigen sowie elektrisch leitenden Verbindung zweier starrer Leiterplattenabschnitte 21,24 zum Fixieren der Einbaulage des Leiterplattenverbunds als dreidimensionale Struktur 40 dar.

**Fig. 12** zeigt den in Fig. 11 dargestellten Leiterplattenverbund 20 in einer isometrischen Ansicht schräg von der Seite.

In den Figuren 11 und 12 ist der Leiterplattenverbund 20 jeweils der besseren Übersicht wegen ohne Bestückung mit elektronischen Bauteilen gezeigt. Die beiden starren Leiterplattenabschnitte 21 und 24 sind an ihren Rändern mit einer formschlüssigen Verbindung in Form einer Spundung mit mehreren Rastnasen 50 und dazu komplementären Rastnuten 51, in die die Rastnasen 50 eingreifen, zusammengesteckt. Um zusätzlich auch signalleitende elektrische Verbindungen zwischen den beiden zusammengesteckten starren Leiterplattenabschnitten 21,24 zu erzielen, sind entsprechende Leiterbahnen bzw. Kontakte an den einander berührenden Rändern der starren Leiterplattenabschnitte 21,24 an Lötflächen 52 bzw. Lötpads 52 miteinander verlötet. Durch die Lötstellen wird zusätzlich auch der Leiterplattenverbund 20 in seiner Einbaulage stabilisiert und ein unbeabsichtigtes Öffnen der zusammengesteckten starren Leiterplattenabschnitten 21,24 verhindert. Entsprechende Durchkontaktierungen 53, sogenannte Vias 53, die direkt angrenzend an die Lötflächen 52 bzw. Lötpads 52 angeordnet sind, dienen hier aufgrund des jeweils mehrlagigen Aufbaus der Leiterplattenabschnitte 21,24 dazu, um entsprechende Leiterbahnen lagenweise korrekt elektrisch signalleitend an den entsprechenden Lötstellen 54 miteinander zu verbinden. Die Durchkontaktierungen bzw. Vias 53 können an den Rändern der entsprechenden starren Leiterplattenabschnitte 21,24 auch als "halbe" Vias 53, also als in Längsrichtung der Durchkontaktierungen 53 zur Hälfte geöffnete Vias 53 ausgeführt sein. Aus Gründen der Übersichtlichkeit sind die Lötstellen 54, welche nach dem Verlöten die Lötflächen 52 sowie die Vias 53 mit Lot überdecken, nur strichliert angedeutet.

### BEZUGSZEICHENLISTE

- 1: Modul
- 2: Modulgehäuse
- 3: Innenraum des Modulgehäuses
- 4: Innenwandung des Modulgehäuses
- 5: herkömmliche Leiterplatte (Stand der Technik)
- 6: Stiftleistenverbindung
- 7: erste Leiterplatte
- 8: zweite Leiterplatte
- 10: elektronisches Bauteil
- 11: wärmeerzeugendes elektronisches Bauteil
- 12: Netzteil
- 13: Microcontroller; Halbleiterchip
- 14: temperaturempfindliches elektronisches Bauteil
- 20: abschnittsweise flexibler Leiterplattenverbund
- 21: erster starrer Leiterplattenabschnitt
- 22: zweiter starrer Leiterplattenabschnitt
- 23: dritter starrer Leiterplattenabschnitt
- 24: vierter starrer Leiterplattenabschnitt
- 25: fünfter starrer Leiterplattenabschnitt
- 26: sechster starrer Leiterplattenabschnitt
- 31: erster flexibler Leiterplattenabschnitt
- 32: zweiter flexibler Leiterplattenabschnitt
- 33: dritter flexibler Leiterplattenabschnitt
- 34: vierter flexibler Leiterplattenabschnitt
- 35: fünfter flexibler Leiterplattenabschnitt
- 40: dreidimensionale, räumliche Struktur
- 41: erste Ebene der räumlichen Struktur
- 42: zweite Ebene der räumlichen Struktur
- 43: dritte Ebene der räumlichen Struktur
- 44: vierte Ebene der räumlichen Struktur
- 45: fünfte Ebene der räumlichen Struktur
- 49: Abstandhalter
- 50: formschlüssige Verbindung; Rastnase
- 51: formschlüssige Verbindung; Rastnut
- 52: Lötfläche; Lötpad
- 53: Durchkontaktierung (Via)
- 54: Lötkontaktstelle
- 60: Ausnehmung für Strommesssensor
- 61: Strommesssensor
- 100: Messmodul
- 101: Kommunikationsmodul
- 211: erste Außenseite des ersten starren Leiterplattenabschnitts
- 212: zweite Außenseite des ersten starren Leiterplattenabschnitts
- α: erster Winkel zwischen starren Leiterplattenabschnitten
- β: zweiter Winkel zwischen starren Leiterplattenabschnitten
- γ: dritter Winkel zwischen starren Leiterplattenabschnitten
- δ: vierter Winkel zwischen starren Leiterplattenabschnitten
- ε: fünfter Winkel zwischen starren Leiterplattenabschnitten

## Patentansprüche

1. Modul (1), insbesondere zur Anordnung in einem Schaltschrank eines Niederspannungsverteilers, wobei das Modul (1) ein Modulgehäuse (2) umfasst, wobei innerhalb des Modulgehäuses (2) ein abschnittsweise flexibler Leiterplattenverbund (20) mit zumindest drei starren Leiterplattenabschnitten (21,22,23,24,25,26) sowie mit zumindest zwei flexiblen Leiterplattenabschnitten (31,32,33,34,35) angeordnet ist, wobei jeweils zumindest ein flexibler Leiterplattenabschnitt (31,32,33,34,35) zwischen zwei benachbarten starren Leiterplattenabschnitten (21,22,23,24,25,26) angeordnet und mit diesen zwei benachbarten starren Leiterplattenabschnitten (21,22,23,24,25,26) signalleitend elektrisch verbunden ist, wobei der abschnittsweise flexible Leiterplattenverbund (20) in Einbaulage innerhalb des Modulgehäuses (2) eine dreidimensionale Struktur (40) bildet, bei der zumindest ein erstes Paar zweier benachbarter starrer Leiterplattenabschnitte (21,22) zueinander einen ersten Winkel (α) einschließt und zumindest ein zweites Paar zweier benachbarter starrer Leiterplattenabschnitte (22,23) zueinander einen zweiten Winkel (β) einschließt, **dadurch gekennzeichnet, dass** zwei starre Leiterplattenabschnitte (21,22,23,24,25,26) in Einbaulage innerhalb des Modulgehäuses (2) mit einer formschlüssigen Steck- oder Rastverbindung (50,51) zusammengefügt sind, wobei die formschlüssige Steck- oder Rastverbindung (50,51) zusätzlich verlötet ist, wobei temperaturempfindliche elektronische Bauteile (13,14) auf dem abschnittsweise flexiblen Leiterplattenverbund (20) in Einbaulage der dreidimensionalen Struktur (40) räumlich beabstandet von wärmeerzeugenden elektronischen Bauteilen (11,12) angeordnet sind.

2. Modul (1) nach Anspruch 1, **dadurch gekennzeichnet, dass** jeweils zwei benachbarte starre Leiterplattenabschnitte (21,22,23,24,25,26) zueinander einen Winkel (α,β,γ,δ,ε) in einem Bereich von 10° bis 170°, vorzugsweise in einem Bereich von 30° bis 150°, besonders bevorzugt in einem Bereich von 60° bis 120°, einschließen.

3. Modul (1) nach Anspruch 1 oder 2, **dadurch gekennzeichnet, dass** die Winkel (α, β,γ,δ,ε) zwischen jeweils zwei benachbarten starren Leiterplattenabschnitten (21,22,23,24,25,26) jeweils gleich groß sind.

4. Modul (1) nach Anspruch 1 oder 2, **dadurch gekennzeichnet, dass** die Winkel (α, β,γ,δ,ε) zwischen jeweils zwei benachbarten starren Leiterplattenabschnitten (21,22,23,24,25,26) jeweils unterschiedlich groß oder in Gruppen unterschiedlich groß sind.

5. Modul (1) nach einem der Ansprüche 1 bis 4, **dadurch gekennzeichnet, dass** jeder starre Leiterplattenabschnitt (21,22,23,24,25,26) in Einbaulage innerhalb des Modulgehäuses (2) jeweils eine, vorzugsweise jeweils eine eigene, Ebene (41,42,43,44,45) der dreidimensionalen Struktur (40) bildet.

6. Modul (1) nach einem der Ansprüche 1 bis 5, **dadurch gekennzeichnet, dass** zumindest zwei starre Leiterplattenabschnitte (21,22,23,24,25,26) in Einbaulage innerhalb des Modulgehäuses (2) mit einer lösbaren formschlüssigen Verbindung (50,51) miteinander verbindbar sind.

7. Modul (1) nach Anspruch 6, **dadurch gekennzeichnet, dass** die lösbare formschlüssige Verbindung (50,51) ausgewählt ist aus der Gruppe umfassend, vorzugsweise bestehend aus: Rastverbindung, Steckverbindung, Nut-Feder-Verbindung, Spundung, Passfeder-Verbindung, Reißverschluss-Verbindung, Klettverschluss-Verbindung.

8. Modul (1) nach einem der Ansprüche 1 bis 7, **dadurch gekennzeichnet, dass** der abschnittsweise flexible Leiterplattenverbund (20) ausgewählt ist aus der Gruppe umfassend, vorzugsweise bestehend aus: starrflexibler Leiterplattenverbund, semiflexibler Leiterplattenverbund, flexibler Leiterplattenverbund verklebt auf Aluminiumplatten.

9. Modul (1) nach einem der Ansprüche 1 bis 8, **dadurch gekennzeichnet, dass** zumindest zwei gleich große starre Leiterplattenabschnitte (21,22,23,24,25,26) ausgebildet sind, welche in Einbaulage des abschnittsweise flexiblen Leiterplattenverbunds (20) innerhalb des Modulgehäuses (2) einander gegenüberliegend angeordnet sind.

10. Modul (1) nach einem der Ansprüche 1 bis 9, **dadurch gekennzeichnet, dass** zumindest ein starrer Leiterplattenabschnitt (21,22,23,24,25,26) beidseitig auf zwei voneinander weg weisenden Außenseiten (211,212) mit elektronischen Bauteilen (10,11,12,13,14) bestückt ist.

11. Modul (1) nach einem der Ansprüche 1 bis 10, **dadurch gekennzeichnet, dass** das Modul (1) ein Messmodul (100) für ein Schaltgerät, insbesondere für einen Lasttrennschalter, zum Messen zumindest einer Messgröße in einem Niederspannungsnetz, und/oder ein Kommunikationsmodul (101) ist.

12. Modul (1) nach einem der Ansprüche 1 bis 11, **dadurch gekennzeichnet, dass** das Modulgehäuse (2) als Tragschienengehäuse, vorzugsweise als Hutschienengehäuse, ausgebildet ist.

13. Schaltschrank, insbesondere eines Niederspannungsverteilers, wobei im Schaltschrank zumindest ein Modul (1) nach einem der Ansprüche 1 bis 12 angeordnet ist.

## Claims

1. A module (1), in particular for arranging in a switchgear cabinet of a low-voltage distributor, the module (1) comprising a module housing (2), a printed circuit board combination (20) that is flexible in portions and comprises at least three rigid printed circuit board portions (21, 22, 23, 24, 25, 26) and at least two flexible printed circuit board portions (31, 32, 33, 34, 35) being arranged within the module housing (2), each at least one flexible printed circuit board portion (31, 32, 33, 34, 35) being arranged between two adjacent rigid printed circuit board portions (21, 22, 23, 24, 25, 26) and being electrically connected to these two adjacent rigid printed circuit board portions (21, 22, 23, 24, 25, 26) in a signal-conducting manner, the printed circuit board combination (20) that is flexible in portions forming a three-dimensional structure (40) in an installation position within the module housing (2), in which structure at least one first pair of two adjacent rigid printed circuit board portions (21, 22) encloses a first angle (α) to one another and at least one second pair of two adjacent rigid printed circuit board portions (22, 23) encloses a second angle (β) to one another, **characterized in that** two rigid printed circuit board portions (21, 22, 23, 24, 25, 26) are joined together with a form-fitting plug-in connection or latched connection (50, 51) in the installation position within the module housing (2), the form-fitting plug-in connection or latched connection (50, 51) being additionally soldered, temperature-sensitive electronic components (13, 14) being arranged to be spatially spaced apart from heat-generating electronic components (11, 12) on the printed circuit board combination (20) that is flexible in portions in the installation position of the three-dimensional structure (40).

2. The module (1) according to claim 1, **characterized in that** each two adjacent rigid printed circuit board portions (21, 22, 23, 24, 25, 26) enclose an angle (α, β, γ, δ, ε) to one another in a range of 10° to 170°, preferably in a range of 30° to 150°, particularly preferably in a range of 60° to 120°.

3. The module (1) according to claim 1 or 2, **characterized in that** the angles (α, β, γ, δ, ε) between each two adjacent rigid printed circuit board portions (21, 22, 23, 24, 25, 26) are each the same.

4. The module (1) according to claim 1 or 2, **characterized in that** the angles (α, β, γ, δ, ε) between each two adjacent rigid printed circuit board portions (21, 22, 23, 24, 25, 26) are each different or are each different in groups.

5. The module (1) according to any one of claims 1 to 4, **characterized in that** each rigid printed circuit board portion (21, 22, 23, 24, 25, 26) forms a plane (41, 42, 43, 44, 45), preferably a separate plane, of the three-dimensional structure (40) in the installation position within the module housing (2).

6. The module (1) according to any one of claims 1 to 5, **characterized in that** at least two rigid printed circuit board portions (21, 22, 23, 24, 25, 26) can be interconnected by a detachable form-fitting connection (50, 51) in the installation position within the module housing (2).

7. The module (1) according to claim 6, **characterized in that** the detachable form-fitting connection (50, 51) is selected from the group comprising, preferably consisting of: a latched connection, a plug-in connection, a slip-tongue connection, a tongue and groove connection, a feather key connection, a zipper connection, or a hook and loop connection.

8. The module (1) according to any one of claims 1 to 7, **characterized in that** the printed circuit board combination (20) that is flexible in portions is selected from the group comprising, preferably consisting of: a rigid-flexible printed circuit board combination, a semi-flexible printed circuit board combination, or a flexible printed circuit board combination bonded to aluminum plates.

9. The module (1) according to any one of claims 1 to 8, **characterized in that** at least two rigid printed circuit board portions (21, 22, 23, 24, 25, 26) of the same size are formed which are arranged opposite one another in the installation position of the printed circuit board combination (20) that is flexible in portions within the module housing (2).

10. The module (1) according to any one of claims 1 to 9, **characterized in that** at least one rigid printed circuit board portion (21, 22, 23, 24, 25, 26) is equipped with electronic components (10, 11, 12, 13, 14) on either side on two outer faces (211, 212) pointing away from one another.

11. The module (1) according to any one of claims 1 to 10, **characterized in that** the module (1) is a measurement module (100) for a switchgear, in particular for a load break switch, for measuring at least one measured variable in a low-voltage network, and/or a communication module (101).

12. The module (1) according to any one of claims 1 to 11, **characterized in that** the module housing (2) is configured as a mounting rail housing, preferably as a top-hat rail housing.

13. A switchgear cabinet, in particular of a low-voltage distributor, wherein at least one module (1) according to any one of claims 1 to 12 is arranged in the switchgear cabinet.

## Revendications

1. Module (1), en particulier destiné à s'agencer dans une armoire de commutation d'un distributeur basse tension, le module (1) comprenant un boîtier de module (2), une association de cartes de circuits imprimés (20) qui est souple par parties et est disposée à l'intérieur du boîtier de module (2) et comprend au moins trois parties de carte de circuits imprimés rigides (21, 22, 23, 24, 25, 26) et au moins deux parties de carte de circuits imprimés souples (31, 32, 33, 34, 35), chaque au moins une partie de carte de circuits imprimés souple (31, 32, 33, 34, 35) étant agencée entre deux parties de carte de circuits imprimés rigides (21, 22, 23, 24, 25, 26) adjacentes et étant électriquement connectée à ces deux parties de carte de circuits imprimés rigides (21, 22, 23, 24, 25, 26) adjacentes d'une manière conductrice de signal, l'association de cartes de circuits imprimés (20) qui est souple par parties formant une structure tridimensionnelle (40) dans une position d'installation au sein du boîtier de module (2), structure dans laquelle au moins une première paire de deux parties de cartes de circuits imprimés rigides (21, 22) adjacentes forme un premier angle (α) de l'une avec l'autre et au moins une seconde paire de deux parties de carte de circuits imprimés rigides (22, 23) adjacentes forme un second angle (β) de l'une avec l'autre, **caractérisé en ce que** deux parties de carte de circuits imprimés rigides (21, 22, 23, 24, 25, 26) sont jointes conjointement avec un raccord enfichable à ajustement de forme ou un raccord à loquet (50, 51) dans la position d'installation au sein du boîtier de module (2), le raccord enfichable à ajustement de forme ou le raccord à loquet (50, 51) étant en outre soudés, des composants électroniques sensibles à la température (13, 14) étant agencés pour être espacés spatialement des composants électroniques générant de la chaleur (11, 12) sur l'association de cartes de circuits imprimés (20) qui est souple par parties dans la position d'installation de la structure tridimensionnelle (40).

2. Module (1) selon la revendication 1, **caractérisé en ce que** chaque deux parties de carte de circuits imprimés rigides (21, 22, 23, 24, 25, 26) adjacentes forment un angle (α, β, y, δ, ε) l'une avec l'autre dans une plage de 10° à 170°, de préférence dans une plage de 30° à 150°, particulièrement préférentiellement dans une plage de 60° à 120°.

3. Module (1) selon la revendication 1 ou 2, **caractérisé en ce que** les angles (α, β, y, δ, ε) entre chaque deux parties de carte de circuits imprimés rigides (21, 22, 23, 24, 25, 26) adjacentes sont chacune identiques.

4. Module (1) selon la revendication 1 ou 2, **caractérisé en ce que** les angles (α, β, γ, δ, ε) entre chaque deux parties de carte de circuits imprimés rigides (21, 22, 23, 24, 25, 26) adjacentes sont chacune différentes ou sont chacune différentes par groupes.

5. Module (1) selon l'une quelconque des revendications 1 à 4, **caractérisé en ce que** chaque partie de carte de circuits imprimés rigide (21, 22, 23, 24, 25, 26) forme un plan (41, 42, 43, 44, 45), de préférence un plan séparé, de la structure tridimensionnelle (40) dans la partie d'installation au sein du boîtier de module (2).

6. Module (1) selon l'une quelconque des revendications 1 à 5, **caractérisé en ce que** au moins deux parties de carte de circuits imprimés rigides (21, 22, 23, 24, 25, 26) peuvent être interconnectées en position d'installation à l'intérieur du boîtier du module (2) par une connexion de verrouillage positif (50, 51) détachable.

7. Module (1) selon la revendication 6, **caractérisé en ce que** la connexion de verrouillage positif (50, 51) détachable est choisi dans le groupe comprenant, de préférence constitué par : un raccord à loquet, un raccord enfichable, un raccord à glissement de languette, un raccord à rainure et languette, un raccord à clavette, un raccord à fermeture éclair ou un raccord velcro.

8. Module (1) selon l'une quelconque des revendications 1 à 7, **caractérisé en ce que** l'association de cartes de circuits imprimés (20) qui est souple par parties est choisie dans le groupe comprenant, de préférence constitué par : une association de cartes de circuits imprimés rigides-souples, une association de cartes de circuits imprimés semi-souples ou une association de cartes de circuits imprimés souples liées à des plaques d'aluminium.

9. Module (1) selon l'une quelconque des revendications 1 à 8, **caractérisé en ce que** au moins deux parties de carte de circuits imprimés rigides (21, 22, 23, 24, 25, 26) de la même taille sont formées et agencés à l'opposé l'une de l'autre dans la position d'installation de l'association de cartes de circuits imprimés (20) qui est souple par parties au sein du boîtier de module (2).

10. Module (1) selon l'une quelconque des revendications 1 à 9, **caractérisé en ce que** au moins une partie de carte de circuits imprimés rigide (21, 22, 23, 24, 25, 26) est équipée de composants électroniques (10, 11, 12, 13, 14) sur l'un ou l'autre côté sur deux faces externes (211, 212) orientées dans des directions opposées l'une à l'autre.

11. Module (1) selon l'une quelconque des revendications 1 à 10, **caractérisé en ce que** le module (1) est un module de mesure (100) pour un appareil de commutation, en particulier pour un interrupteur-sectionneur, pour mesurer au moins une variable mesurée dans un réseau basse tension, et/ou un module de communication (101).

12. Module (1) selon l'une quelconque des revendications 1 à 11, **caractérisé en ce que** le boîtier de module (2) est configuré en tant que boîtier sur rail de montage, de préférence en tant que boîtier sur rail à profil chapeau.

13. Armoire de commutation, en particulier d'un distributeur basse tension, dans laquelle au moins un module (1) selon l'une quelconque des revendications 1 à 12 est agencé dans l'armoire de commutation.
